(19)

Europäisches
Patentamt
European
Patent Office
Office européen
des brevets

(11) **EP 2 306 501 A2**

(12) **EUROPEAN PATENT APPLICATION**

(43) Date of publication:
06.04.2011 Bulletin 2011/14

(51) Int Cl.:
*H01L 21/48* (2006.01)     *H01L 23/373* (2006.01)

(21) Application number: **10185725.8**

(22) Date of filing: **01.10.2010**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br><br>(30) Priority: **02.10.2009 JP 2009230883**<br>       **28.09.2010 JP 2010216435**<br><br>(71) Applicant: **IBIDEN CO., LTD.**<br>       **Ogaki-shi, Gifu 503-8604 (JP)** | (72) Inventors:<br> • **Furuichi, Wataru**<br>  **Gifu 501-0695 (JP)**<br> • **Honda, Hirokazu**<br>  **Gifu 501-0695 (JP)**<br><br>(74) Representative: **HOFFMANN EITLE**<br>       **Patent- und Rechtsanwälte**<br>       **Arabellastraße 4**<br>       **81925 München (DE)** |

(54)    **Ceramic wiring board and method of manufacturing thereof**

(57)    A manufacturing method of a ceramic wiring board includes steps of: forming a copper layer on a ceramic substrate through a low-temperature growth technique (step S13), increasing a temperature of the copper layer at equal to or higher than an annealing temperature of copper (step S16), and cooling the copper layer after the temperature increasing (step S18).

FIG.4

**Description**

The present invention relates to a ceramic wiring board having a copper layer on a ceramic substrate, and more particularly, a ceramic wiring board having, for example, a large-current semiconductor device mounted on the copper layer, and a method of manufacturing such a ceramic wiring board.

Wiring substrates having a wiring pattern on an insulation substrate are used as general substrates for mounting a semiconductor device. As a power wiring board, a ceramic substrate is appropriate which has a larger thermal conductivity than that of a resin substrate and has a high heatproof temperature because the semiconductor device generates a large amount of heat. Moreover, a ceramic wiring board having a thick wiring pattern formed on the ceramic substrate in order to feed a large current to the semiconductor device is widely used. In particular, as is widely distributed in the industries, has a good workability, and has a large electrical conductivity, copper is widely used as a wiring pattern.

For ceramic wiring boards having a wiring pattern that is a thick copper layer on the ceramic substrate, the following structure is well known.

For example, Unexamined Japanese Patent Application KOKAI Publication No. 2001-217362 (see, in particular, claim 8) discloses a ceramic wiring board (a wiring board by brazing technique) having a bonding layer formed on a ceramic substrate by sputtering, and having a copper foil bonded thereon by a brazing material.

Moreover, Unexamined Japanese Patent Application KOKAI Publication No. H10-4156 discloses a wiring board having a brazing material which contains active metals like titanium, and which bonds a ceramic substrate and a copper foil without formation of any bonding layer beforehand by sputtering.

Furthermore, Unexamined Japanese Patent Application KOKAI Publication No. S64-59986 discloses a ceramic wiring board (a wiring board by direct bonding technique) having a ceramic substrate and a copper foil arranged so as to directly contact with each other, and having, for example, a $Cu\text{-}Cu_2O$ eutectic liquid phase produced at an interface therebetween to bond those together without a brazing material.

Because those ceramic wiring boards disclosed in the foregoing patent literatures have a feature of coping with a large current by appropriately setting the thickness of the copper foil to be bonded, such ceramic wiring boards are often used as large-current wiring boards.

Still further, Unexamined Japanese Patent Application KOKAI Publication No. 2003-17837 (see, in particular, claim 3) discloses a technique of performing heat treating on a wiring board comprising a ceramic base body (substrate), an undercoat film (bonding layer), and a copper wiring pattern formed by plating. According to this technique, an adhesiveness strength between the ceramic base body and the copper wiring pattern can be enhanced.

In the case of bonding using a brazing material, as disclosed in Unexamined Japanese Patent Application KOKAI Publications No. 2001-217362 and No. H10-4156, because the brazing material itself is a blended material of various metals, those metals form an eutectic alloy, and a hard intermediate layer is thus formed in many cases. As the temperature of the substrate used as a final product becomes 100 °C or so, the hard intermediate layer formed in this fashion may damage a substrate or may cause the wiring pattern to be easily delaminated as a heat cycle between a use temperature and a room temperature is applied. In addition, a brazing material of several 10 $\mu$m is requisite for bonding, there is a limit to suppress any negative effect of the brazing material and to reduce thermal stress, and it becomes also necessary to enhance the strength of the substrate.

According to the direct bonding technique disclosed in Unexamined Japanese Patent Application KOKAI Publication No. S64-59986, bonding is carried out by heating at equal to or lower than a melting point (1083 °C) of copper and equal to or higher than the eutectic temperature (1065 °C) of copper oxide ($Cu_2O$) and copper. In the case of a copper foil and a ceramic substrate, however, it is difficult to obtain a sufficient bonding strength unless all surfaces are contacted with each other and load is uniformly applied thereto at the time of bonding. According to such a power wiring board, portions with a poor bonding strength start delaminating when in use in a repeating manner, so that a reliability for bonding for heat dissipation is insufficient.

According to the ceramic substrate disclosed in Unexamined Japanese Patent Application KOKAI Publication No. 2003-17837, the bonding strength between the undercoat layer on the ceramic substrate and a plated copper is enhanced by heat treating. Accordingly, delamination is not likely to occur, but because of a heat cycle applied to the power wiring board, stress is applied to the ceramic substrate, and the substrate is likely to be cracked.

It is an object of the present invention to provide a ceramic wiring board that suppresses any cracking of the substrate and delamination of a wiring pattern even if a heat cycle is repeated although such a ceramic substrate has a copper layer thereon, and an appropriate method of manufacturing such a ceramic wiring board.

A manufacturing method of a ceramic wiring board according to a first aspect of the present invention is characterized by including steps of: forming a copper layer (13) on a ceramic substrate (10) by a low-temperature growth technique; increasing a temperature of the copper layer (13) at equal to or higher than an annealing temperature of copper; and cooling the copper layer (13) after the temperature increasing.

A ceramic wiring board according to a second aspect of the present invention is characterized by comprising: a ceramic substrate (10); a copper layer (13) formed on the ceramic substrate (10); wherein an average copper grain radius in the copper layer (13) is equal to or larger than 10 μm.

According to the present invention, there is provided a ceramic wiring board which can suppress any cracking of the ceramic substrate and delamination of a wiring pattern even if a heat cycle between a room temperature and a use temperature is applied.

FIG. 1 is a perspective view showing a ceramic wiring board according to an embodiment of the present invention;

FIG. 2 is a cross-sectional view along a line A-A' in FIG. 1;

FIG. 3 is a diagram for explaining a discrimination method between a crystal grain of copper and a crystal fault thereof;

FIG. 4 is a flowchart showing a first manufacturing method of the ceramic wiring board according to the embodiment of the present invention;

FIG. 5A is a diagram for explaining a first step in the first manufacturing method of the ceramic wiring board;

FIG. 5B is a diagram for explaining a second step following the step in FIG. 5A;

FIG. 5C is a diagram for explaining a third step following the step in FIG. 5B;

FIG. 6A is a diagram for explaining a fourth step following the step in FIG. 5C;

FIG. 6B is a diagram for explaining a fifth step following the step in FIG. 6A;

FIG. 6C is a diagram for explaining a sixth step following the step in FIG. 6B;

FIG. 7 is a flowchart showing a second manufacturing method of the ceramic wiring board according to the embodiment of the present invention;

FIG. 8A is a diagram for explaining a first step in the second manufacturing method of the ceramic wiring board;

FIG. 8B is a diagram for explaining a second step following the step in FIG. 8A;

FIG. 8C is a diagram for explaining a third step following the step in FIG. 8B;

FIG. 9A is a diagram for explaining a fourth step following the step in FIG. 8C;

FIG. 9B is a diagram for explaining a fifth step following the step in FIG. 9A;

FIG. 9C is a diagram for explaining a sixth step following the step in FIG. 9B;

FIG. 10A is a cross-sectional view showing respective structures of samples 1 and 2 (examples 1 and 2) manufactured through the manufacturing method of the embodiment of the present invention;

FIG. 10B is a cross-sectional view showing respective structures of samples 3 and 4 (comparative examples 1 and 2) manufactured through a manufacturing method of a comparative example;

FIG. 11 is an SEM (Scanning Electron Microscope) photograph of a whole cut cross section of the sample 1 (heat treatment: 800 °C) at a magnification of 500;

FIG. 12A is an SEM photograph of a part of a copper layer of the sample 1 at a magnification of 1000;

FIG. 12B is an SEM photograph of a part of the copper layer of the sample 1 at a magnification of 5000;

FIG. 13 is an SEM photograph of a whole cut cross section of the sample 2 (heat treatment: 600 °C) at a magnification of 500;

FIG. 14A is an SEM photograph of a part of a copper layer of the sample 2 at a magnification of 1000;

FIG. 14B is an SEM photograph of a part of the copper layer of the sample 2 at a magnification of 5000;

FIG. 15 is an SEM photograph of a whole cut cross section of the sample 3 (heat treatment: 350 °C) at a magnification of 500;

FIG. 16A is an SEM photograph of a part of a copper layer of the sample 3 at a magnification of 1000:

FIG. 16B is an SEM photograph of a part of the copper layer of the sample 3 at a magnification of 5000;

FIG. 17 is an SEM photograph of a whole cut cross section of the sample 4 (no heat treatment applied) at a magnification of 500;

FIG. 18A is an SEM photograph of a part of a copper layer of the sample 4 at a magnification of 1000;

FIG. 18B is an SEM photograph of a part of the copper layer of the sample 4 at a magnification of 5000;

FIG. 19 is a table showing a calculation result of an average copper grain radius for each of the samples 1 to 4;

FIG. 20 is a table showing a result of a substrate crack test for each of the samples 1 to 4;

FIG. 21A is a diagram showing a crack produced on the surface of a ceramic substrate in the case of the sample 3 (comparative example 1) after the substrate crack test;

FIG. 21B is a cross-sectional view along a line A-A' in FIG. 21A;

FIG. 22 is a table showing a result of delamination test for each of the sample 1 (example 1) and the sample 4 (comparative example 2);

FIG. 23 is a table showing a relationship between a heat treatment temperature and a measured elastic modulus (Young's modulus) for each of plated copper and a copper foil;

FIG. 24 is a graph showing a relationship between a heat treatment temperature and a measured elastic modulus (Young's modulus) for each of plated copper and a copper foil;

FIG. 25 is a diagram showing an illustrative ceramic wiring board having copper layers formed on both surfaces and configuring a wiring pattern;

FIG. 26 is a diagram showing an illustrative ceramic wiring board having a wiring conductor layer formed on only one side face of a ceramic substrate;

FIG. 27 is a diagram showing an illustrative ceramic wiring board having only a solid-pattern wiring conductor layer (stress relief layer) on a ceramic substrate;

FIG. 28A is a diagram showing a first example of a ceramic wiring board with a seed layer being omitted;

FIG. 28B is a diagram showing a second example of a ceramic wiring board with a seed layer being omitted;

FIG. 28C is a diagram showing a third example of a ceramic wiring board with a seed layer being omitted;

FIG. 28D is a diagram showing a fourth example of a ceramic wiring board with a seed layer being omitted;

FIG. 29 is a flowchart showing another example of a manufacturing method of the ceramic wiring board of the embodiment of the present invention; and

FIG. 30 is a flowchart showing the other example of a manufacturing method of the ceramic wiring board of the embodiment of the present invention.

A detailed explanation will be given of an embodiment of the present invention with reference to the accompanying drawings.

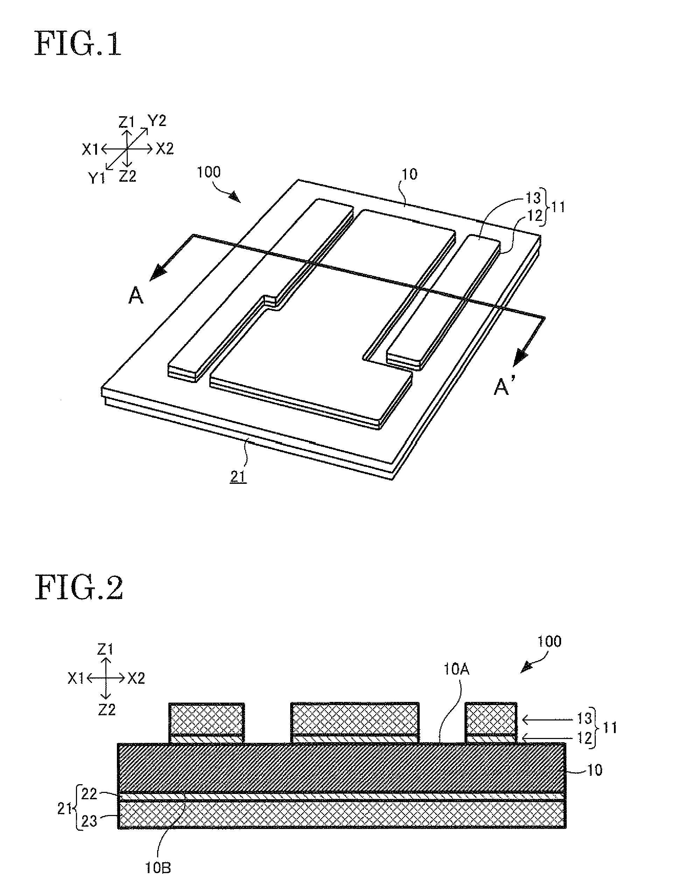

FIG. 1 is a perspective view showing a ceramic wiring board 100 according to an embodiment of the present invention. FIG. 2 is a cross-sectional view along a line A-A' in FIG. 1. In the figures, arrows X1, X2, Y1, Y2, Z1, and Z2 indicate six directions relating to three axes (X, Y, and Z axes) orthogonal to one another. For simplifying explanation, a face of a ceramic substrate 10 at the Z1 side (X-Y plane) is defined as a front face, and a face at the Z2 side (X-Y plane) is defined as a rear face.

The ceramic wiring board 100 of the embodiment comprises, as shown in FIGS. 1 and 2, a ceramic substrate 10, a first wiring conductor layer 11, and a second wiring conductor layer 21. The first wiring conductor layer 11 is formed on a first face 10A (front face) of the ceramic substrate 10, and forms a wiring pattern. The second wiring conductor layer 21 is formed on a whole second face 10B (rear face) opposite to the first face 10A.

A ceramic material configuring the ceramic substrate 10 is not limited to any particular one, but beryllium oxide, aluminum nitride, or silicon nitride is desirable. The ceramic substrate 10 made of such ceramic material is an insulating body having a high thermal conductivity, and can be appropriately used as a base material of the ceramic wiring board 100 having a wiring pattern. In particular, aluminum nitride, silicon nitride are harmless, and are preferable as the material of the ceramic substrate 10.

The first wiring conductor layer 11 comprise a seed layer 12 and a copper layer 13 successively stacked in this order on the first face 10A of the ceramic substrate 10. Moreover, the second wiring conductor layer 21 comprises a seed layer 22 and a copper layer 23 successively stacked in this order on the whole second face 10B of the ceramic substrate 10. That is, according to the embodiment, the copper layers 13, 23 are formed on both surfaces of the ceramic substrate 10. Moreover, the copper layers 13, 23 in the embodiment are each a growth layer of copper with a large grain radius (in more detail, copper with an average grain radius equal to or larger than 10 $\mu$m).

The seed layers 12, 22 each functions as a bonding layer for bonding the ceramic substrate 10 and each of the copper layers 13, 23 together. In the embodiment, the seed layers 12, 22 are made of a high-melting-point metal. That is, the copper layers 13, 23 are formed on the ceramic substrate 10 via respective seed layers 12, 22 made of a high-melting-point metal.

Examples of the high-melting-point metal appropriately used for the seed layers 12, 22 are a single metal, such as Ti, Ni, Cr, or Zr, and an alloy thereof. More specifically, when the ceramic substrate 10 and the copper layers 13, 23 are bonded together by a brazing material, it is anxious that the brazing material may form copper and a eutectic alloy, which brings about a crack of the ceramic substrate 10 and delamination of the copper layers 13, 23. In contrast, when the ceramic substrate 10 and the copper layers 13, 23 are bonded together by the seed layers 12, 22 made of a high-melting-point metal, a eutectic temperature can be set to be high, so that a temperature of a heat treatment is not likely to exceed a melting point of the seed layers 12, 22, thereby suppressing formation of any alloy metal layer made of a eutectic alloy harder than copper. Among the high-melting-point metals, in particular, Ti is known to from a compound, such as $TiN_x$, or $TiO_x$, with various ceramic base materials, and can be appropriately used as a high bonding strength with the ceramic substrate 10 can be obtained.

It is desirable that each seed layer 12, 22 should have a thickness equal to or thinner than 1 $\mu$m. If such a thickness exceeds 1 $\mu$m, the seed layer 12 becomes hard, so that thermal stress is likely to be produced. More specifically, when large force is applied at an interface between individual layers due to thermal stress produced, the ceramic substrate 10 is likely to be cracked and the copper layers 13, 23 are likely to be delaminated. It is further desirable that each seed layer 12, 22 should have a thickness equal to or thinner than 0.3 $\mu$m. If the thickness of each seed layer 12, 22 is equal to or thinner than 0.3 $\mu$m, a pore in the polished ceramic substrate 10 is not completely blocked with a high possibility, so that a pore corresponding to the pore of original ceramic remains in the surface of the ceramic substrate 10 after the seed layers 12, 22 are formed, thereby enhancing a bonding strength between the ceramic substrate 10 and each copper layer 13, 23.

The copper layer 23 is a conductor pattern (solid pattern) formed across a whole face (whole area of X-Y plane) of the seed layer 22, and functions as a stress relief layer. That is, the copper layer 23 suppresses any retroflex of the ceramic wiring board 100. Moreover, as the copper layers 13, 23 are formed on both surfaces of the ceramic substrate 10, bending stress applied to the ceramic substrate 10 is eased as thermal strain acts on both surfaces of the ceramic substrate 10. Accordingly, it is possible to prevent the ceramic substrate 10 from being cracked. Furthermore, it is possible to further obtain a function of reducing noises and the like by electrically connecting (grounding) the copper layer 23.

It is preferable that an average grain radius of a copper crystal in the copper layers 13, 23 should be large to some extent, and a specific range of such an average grain radius is equal to or larger than 10 μm, more preferably, equal to or larger than 15 μm, and further preferably, equal to or larger than 20 μm. When the average grain radius of copper in the copper layers 13, 23 is at least equal to or larger than 10 μm, the copper layers 13, 23 become growth layers where crystal growth of copper is sufficiently advanced. Accordingly, the copper layers 13, 23 become soft copper layers, and stress to the copper layers 13, 23 can be eliminated, as a result, the ceramic substrate 10 becomes not likely to be cracked.

However, it is not preferable that the average grain radius of copper in the copper layers 13, 23 is too large. Accordingly, it is preferable that the average grain radius of copper in the copper layers 13, 23 should be in an appropriate range which is not too large, and a specific range thereof is equal to or smaller than 40 μm, and more specifically, equal to or smaller than 35 μm. When the average grain radius of copper in the copper layers 13, 23 is at least equal to or smaller than 40 μm, the copper layers 13, 23 have sufficient strength, so that a conduction failure at a connected part with a lead or the like due to fallout of grains becomes not likely to occur.

From the above explanation, it is especially preferable that the average grain radius of a copper crystal in the copper layers 13, 23 should be within a range which is large to some extent (preferably, equal to or larger than 10 μm, more preferably, equal to or larger than 15 μm, and further preferably, equal to or larger than 20 μm), and is not too large (preferably, equal to or smaller than 40 μm, more preferably, equal to or smaller than 35 μm).

A copper grain radius in the copper layers 13, 23 can be calculated by observing respective cross sections of the copper layers 13, 23 through an electron microscope or the like. An illustrative calculation method will now be explained below.

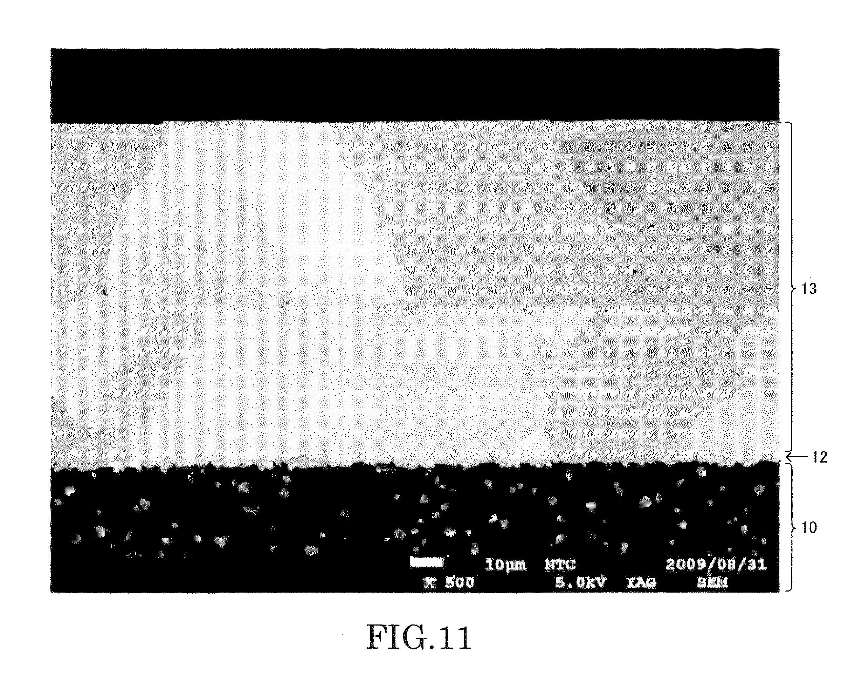

First, images of respective cross sections of the copper layers 13, 23 on the ceramic substrate 10 are picked up. More specifically, for example, the ceramic wiring board 100 is cut into appropriate pieces. Next, such a piece is embedded in a room-temperature-curing type epoxy resin or the like, and Pt-Pd sputtering is performed thereon. The reason why Pt-Pd sputtering is performed is to suppress any charge up by forming a conductor film around such a resin. Thereafter, a sample having a cross section exposed by ion polishing is produced, and the sample is fixed on a sample stage. The cross section is observed through an FE-SEM (Scanning Electron Microscope). Through this method, a photograph shown in FIG. 11 or the like can be obtained. FIG. 11 is an SEM photograph of a cross section of the ceramic wiring board 100 according to an embodiment of the present invention (more specifically, sample 1 for evaluation to be discussed later).

Next, based on the photographs of respective cross sections of the copper layers 13, 23 on the ceramic substrate 10 obtained thus way, a copper grain radius in the copper layers 13, 23 is calculated.

More specifically, first, a rectangular region sufficiently larger than a copper grain size is selected at random, and with a premise that the count number for a copper crystal grain contained in the rectangular region is 1, and the count number for a grain present across a boundary line of the rectangle is 0.5, a total number is counted.

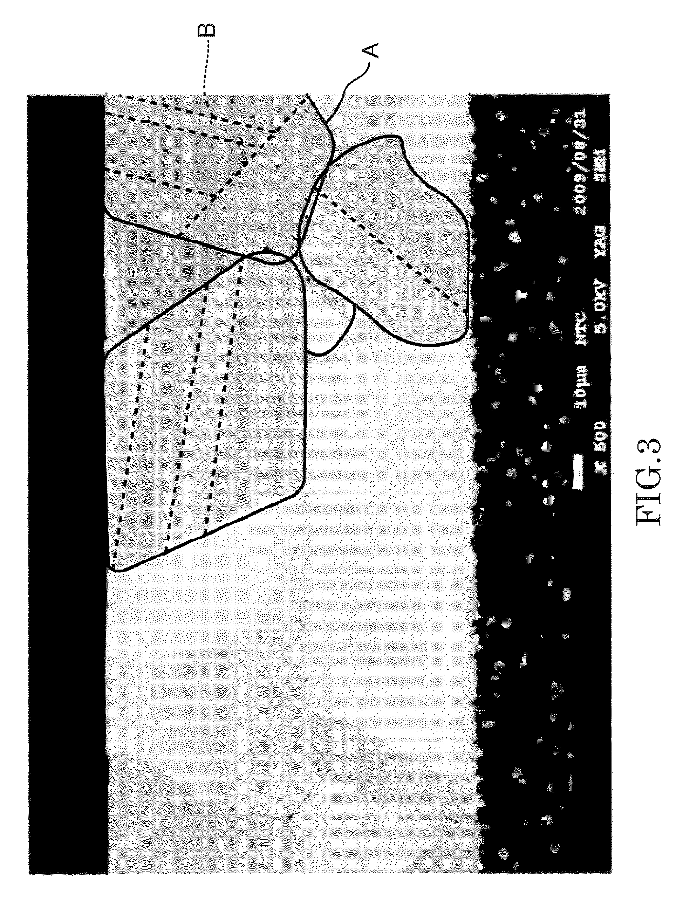

In order to count the number of crystal grains precisely, it is important to make an accurate discrimination between a crystal grain and a crystal fault. In the present embodiment, by utilizing a fact that individual crystals in an SEM photograph are granular, a crystal grain and a crystal fault are discriminated. A straight line boundary is often seen in a crystal grain, but this is a crystal fault, and does not affect to a crystal radius defined in the present embodiment, so that it is eliminated from discrimination. FIG. 3 shows an illustrative result for discrimination of a copper crystal grain and a crystal fault through this discrimination method. In this example, a crystal grain and a crystal fault are discriminated for a partial area of the sample 1 (see FIG. 11) used for evaluation to be discussed later. In FIG. 3, a continuous line indicates a crystal grain boundary A, and a dashed line indicates a crystal fault (transformation) B. Note that regarding a discrimination between a crystal grain and a crystal fault, it is also possible to utilize a fact that a void is present on a boundary line of crystal grains and is not present on a boundary line of a crystal orientation due to transformation.

By dividing a cross-sectional area of the rectangular region by the number of crystals obtained in this fashion, an average cross-sectional area per crystal can be calculated. The average cross-sectional area can be acquired from, for example, the following formula (1).

[Formula 1]

$$\text{Average cross-sectional area} = \text{area of rectangular region/number}$$

Moreover, such average cross-sectional area obtained in this fashion is approximated as a circle, and an average grain radius of a copper crystal can be obtained from the following formula (2).

[Formula 2]

$$\text{Average grain radius} = \sqrt{(\text{average cross-sectional area} \times 4/\pi)}$$

An illustrative method of calculating a copper grain radius in the copper layers 13, 23 using an electron microscope was explained above. According to this method, it is relatively easy to calculate out a copper grain radius in the copper layers 13, 23 from respective cross-sectional images of the copper layers 13, 23 on the ceramic substrate 10.

A preferable range of the elastic modulus of each copper layer 13, 23 is from 30 to 70 GPa, more preferably, from 30 to 60 GPa, and further preferably, from 40 to 60 GPa. More specifically, when the elastic modulus of each copper layer 13, 23 exceeds 70 GPa, large stress is applied to the ceramic substrate 10 when a heat cycle is applied to the ceramic wiring board 100, so that the ceramic substrate 10 is likely to be cracked. Conversely, if the elastic modulus of each copper layer 13, 23 is less than 30 GPa, the deformation amount of copper becomes large, so that metal fatigue is likely to occur, and the copper layers are gradually delaminated at a connection part with a semiconductor device or a connection part with the ceramic substrate 10. In contrast, if the elastic modulus of each copper layer 13, 23 is at least within a range from 30 to 70 GPa, the above-explained thermal stress and copper deformation are suppressed, and any stress to the ceramic substrate 10 is eased, so that the ceramic substrate 10 becomes not likely to be cracked, and a metal fatigue of copper is not likely to occur. As a result, the copper layers 13, 23 are not likely to be delaminated from the ceramic substrate 10.

It is desirable that an average copper grain radius in the copper layers 13, 23 should be equal to or larger than 10 $\mu$m and the elastic modulus of each copper layer 13, 23 should be within a range from 30 to 70 GPa, more desirably, from 30 to 60 GPa, and further desirably, from 40 to 60 GPa. When the average grain radius and the elastic modulus are within respective foregoing ranges, the copper layers 13, 23 become soft, which is advantageous for easing copper stress. Moreover, stress to the ceramic substrate 10 is likely to be eased, so that the ceramic substrate 10 becomes not likely to be cracked, and a metal fatigue of copper is not likely to occur. As a result, cracking of the ceramic substrate 10 hardly occurs, and delamination of the copper layers 13, 23 from the ceramic substrate 10 is easily suppressed.

It is preferable that the copper layer 13 should have a large thickness to some extent, and a specific range of such thickness is equal to or larger than 100 $\mu$m, more preferably, equal to or larger than 200 $\mu$m. If the thickness of the copper layer 13 which is a conductive layer is equal to or larger than 100 $\mu$m, it is possible to cope with a large current of equal to or larger than several ten to hundred amperes. Such a ceramic wiring board 100 can be used as a power device wiring board. That is, the copper layer 13 can configure a power device wiring.

The ceramic wiring board 100 of the embodiment can be manufactured through, for example, following first and second manufacturing methods.

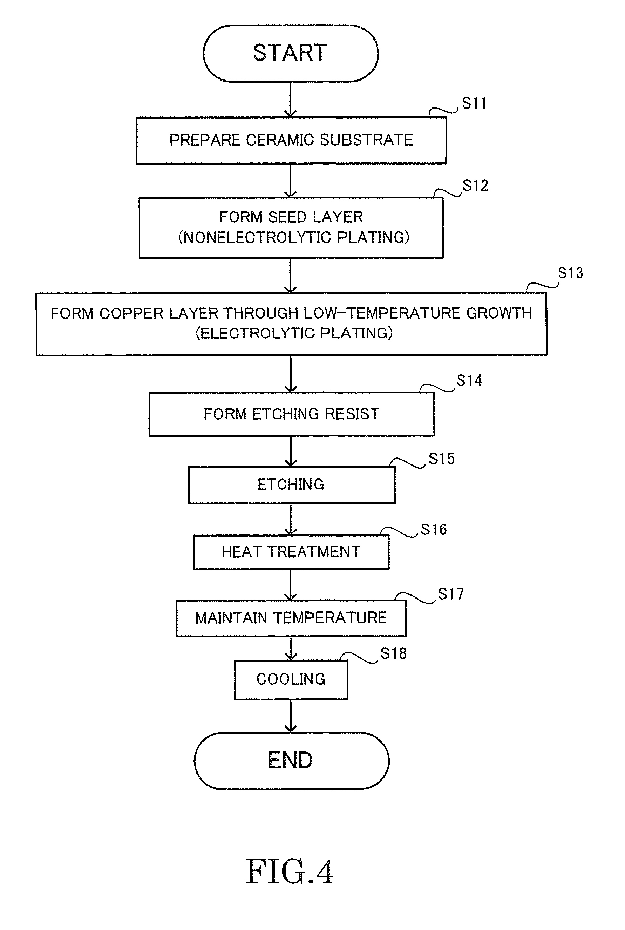

First, with reference to FIG. 4 and the like, an explanation will now be given of the first manufacturing method of the ceramic wiring board 100 of the embodiment. FIG. 4 is a flowchart showing steps of the first manufacturing method.

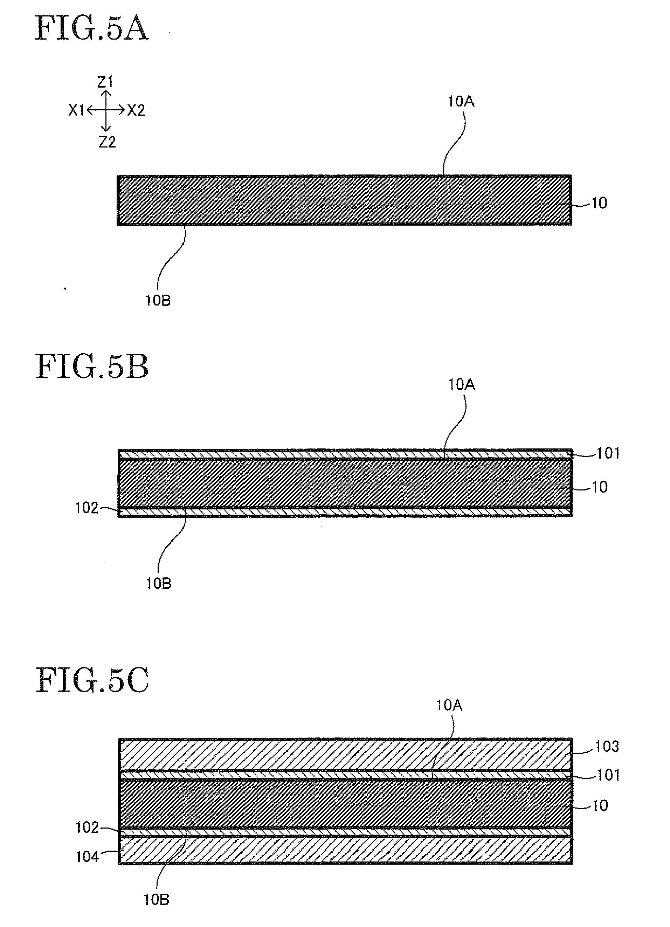

In a step S11, first, as shown in FIG. 5A, the ceramic substrate 10 is prepared.

Next, in a step S12 in FIG. 4, as shown in FIG. 5B, a seed layer 101 is formed on a whole first face 10A (front face) of the ceramic substrate 10, and a seed layer 102 is formed on a whole second face 10B (rear face) of the ceramic substrate 10.

The seed layers 101 and 102 can be formed through any technique, and for example, a non-electrolytic plating technique, a CVD technique, a vacuum vapor deposition technique, and a sputtering technique can be applied. In particular, the sputtering technique is desirable. The sputtering technique has advantages that (1) it is easy to form a covering film using a high-melting-point metal because it is unnecessary to melt a raw-material substance, (2) a motion energy of ionized atom or molecule is large as it is accelerated in an electrical field, and such ionized atom or the like can penetrate in the ceramic substrate 10, so that a covering film with a large adhesiveness can be formed, and (3) thermal strain is hardly produced because the covering film can be formed within a temperature range near a normal temperature, etc.. A condition of the sputtering technique is not limited to any particular one, and for example, the seed layers 101, 102 can be formed by sputtering under an inactive gas atmosphere like Ar, and at a pressure from 1 to 10 Pa.

Next, in a step S13 in FIG. 4, as shown in FIG. 5C, copper layers 103, 104 are formed on respective whole seed layers 101, 102 by low-temperature growth technique. In low-temperature growth technique of the present embodiment, a low temperature indicates a temperature equal to or lower than a heat cycle applied to a power wiring board, and is roughly equal to or less than 150 °C. An explanation will now be given of an advantage of low-temperature growth technique.

According to, for example, a direct bonding technique and a brazing technique, internal stress becomes minimum at a bonding temperature, and the internal stress becomes large at a use temperature of a power wiring board, which often results in delamination of the copper layer and cracking of the ceramic substrate 10. In contrast, according to low-temperature growth technique of the present embodiment, the copper layers 103, 104 are formed at a low temperature, so that internal stress becomes small at a use temperature range of a power wiring board, thereby suppressing any delamination of the copper layers 103, 104 and any cracking of the substrate.

Specific examples of low-temperature growth techniques are a wet technique like plating, and dry techniques, such as a Chemical Vapor Deposition (CVD) technique, a sputtering technique, a vacuum vapor deposition technique, and a Physical Vapor Deposition (PVD) technique.

In particular, a plating technique is preferable as low-temperature growth technique. More specifically, when metal impurities are contained, a hard crystal texture is formed even through a heat treatment performed later, and the copper layers 103, 104 may be hardened. From this aspect, as the copper layers 103, 104 are formed by plating, there is an advantage that the copper layers 103, 104 can be formed at a normal temperature. Accordingly, internal stress can be expressely reduced, and the contained amount of metal impurities becomes little, so that foregoing hardening of the copper layers 103, 104 can be suppressed.

Furthermore, electrolytic plating along plating is desirable. Electrolytic plating has a fast growth rate of the copper layers 103,104, and can easily form the thick copper layers 103,104. More specifically, for example, with the ceramic substrate 10 being set as a cathode, and a copper plate electrode being an anode, those are dipped in a solution like copper sulfate to perform electrolytic plating. The temperature of electrolytic plating is not limited to any particular one, but for example, can be set to be 10 to 40 °C. If the temperature of electrolytic plating is less than 10 °C, the precipitation speed becomes slow. Conversely, if the temperature of electrolytic plating exceeds 40 °C, the precipitation speed becomes fast but growth is accelerated and the quality of plating becomes poor. Accordingly, it is preferable that the temperature of electrolytic plating should be within a range from 10 to 40 °C.

Equal to or greater than two kinds of low-temperature growth techniques can be combined together.

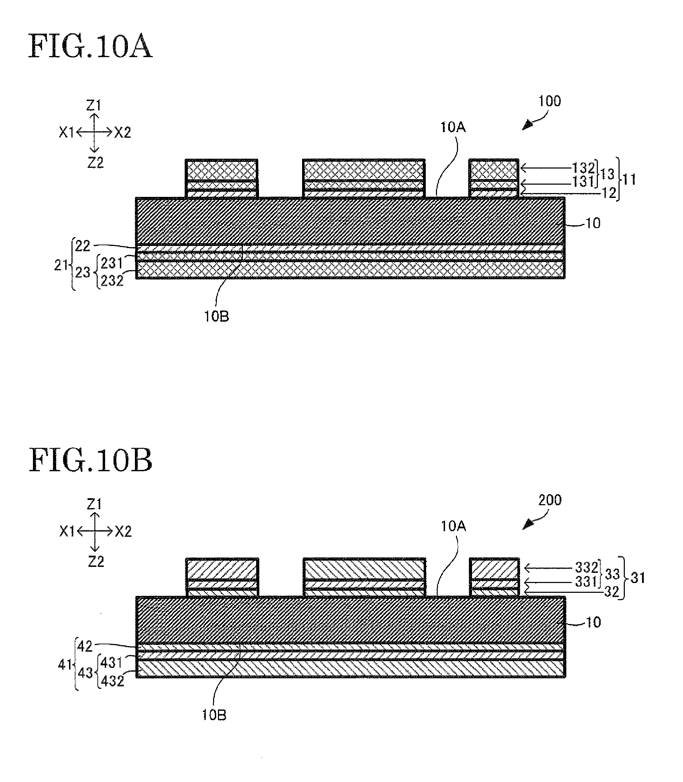

For example, when the thicknesses of respective seed layers 101, 102 are extremely thin, electrical resistance is large, and it is not appropriate for electrolytic plating. In this case, first, a copper thin film of 5 $\mu$m or so is formed by non-electrolytic plating, and the copper layers 103, 104 with a desired thickness are formed thereon by electrolytic plating. For example, when the copper layers 13, 23 are formed by plating, prior to plating, thin copper films of 5 $\mu$m or so may be formed on respective seed layers 101, 102 by sputtering or the like (see FIG. 10A to be discussed later). When a thick copper layer is to be formed by plating, in particular, it is desirable to form such a thick copper layer through formation of a thin copper film by sputtering rather than direct formation on a high-melting-point metal layer. This is because layer stacking on a dissimilar metal with a weak bonding strength by sputtering can enhance bonding to such dissimilar metal. The kind of sputtering is not limited to any particular one, but for example, under an inactive gas atmosphere like Ar, the copper layers 103, 104 with strong adhesiveness with the seed layers 101, 102 that are dissimilar metals can be formed at a pressure of 1 to 10 Pa.

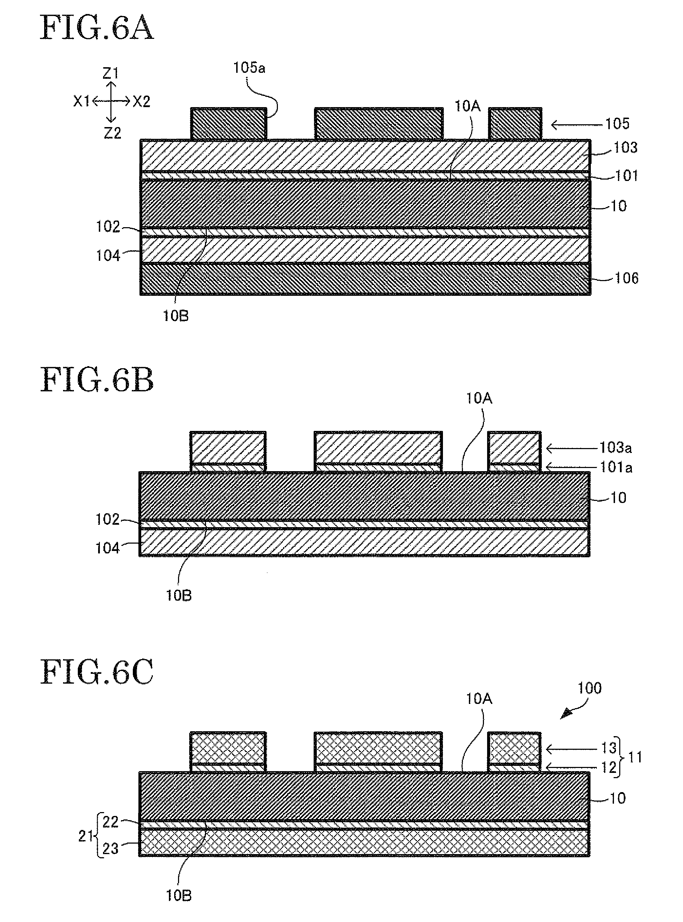

Next, in a step S14 in FIG. 4, as shown in FIG. 6A, photo resists 105, 106 (etching resists) are formed.

More specifically, a photosensitive organic solvent is applied on the copper-layer-103 side, and through a typical exposure/developing technique, the photo resist 105 having an opening 105a at a predetermined location on the copper layer 103 is formed. The photo resist 105 has a pattern corresponding to a wiring pattern.

Conversely, no wiring pattern is formed on the copper layer 104, so that the photo resist 106 is formed on a whole face of the copper layer 104. Note that the photo resist 106 at the copper-layer- 104 side can be formed by any technique like formation through a screen printing instead of photo lithography. However, from the standpoint of efficiency, it is desirable to form the photo resists on both surfaces under the same condition.

Subsequently, in a step S15 in FIG. 4, as shown in FIG. 6B, the copper layer 103 and the seed layer 101 exposed from the photo resist 105 are eliminated by etching. Accordingly, a seed layer 101a and a copper layer 103a both configuring a wiring pattern are formed. Conversely, the copper layer 104 wholly covered by the photo resist 106 is not etched and remains. Thereafter, the photo resists 105, 106 are eliminated.

Next, in a step S16 in FIG. 4, a heat treatment is performed on the ceramic wiring board 100 formed with the copper layers 103 a, 104, to increase the temperature of the copper layers 103a, 104 to equal to or larger than the annealing temperature of copper. The annealing temperature is a temperature which enables reorientation of crystals with different crystal orientations. The annealing temperature of copper is around 600 °C.

A temperature necessary for reorientation of a lattice defect like transformation in a crystal is called a recrystallization temperature. At the recrystallization temperature, although a lattice defect which substantially does not change a crystal orientation and proximate crystals having similar crystal orientations can be reoriented, but proximate crystals having largely different crystal orientations cannot be reoriented. From this point, according to the first manufacturing method of the present embodiment, as the ceramic wiring board is processed at a temperature equal to or higher than the annealing temperature that is higher than the recrystallization temperature, proximate crystals having different crystal orientations can be reoriented and integrated together. As a result, crystal growth of the copper layers 103a, 104 is promoted. Note that crystal growth is substantially completed up to the annealing temperature, so that a crystal size is expected to remain substantially same if the process temperature is increased higher than the annealing temperature.

It is preferable that a heating temperature (a target temperature) at the time of increasing the temperature of copper layers 103a, 104 should be 600 to 900 °C, more preferably, 600 to 800 °C, and further preferably, 700 to 800 °C.

When the heat treatment on the copper layers 103a, 104 is a heat treatment at a temperature less than 600 °C. only lattice defects like transformation of copper are eliminated, but when a heat treatment at a temperature equal to or higher than 600 °C is applied, crystal growth of copper is promote, and a crystal grain becomes large.

When a heat treatment over 900 °C is applied, the copper layers 103a, 104 become softened largely, so that it is not preferable. Moreover, in a case in which, in particular, the seed layers 101a, 102 are provided, a high-melting-point metal is diffused in copper and becomes a solid solution substance, and it is not desirable because the seed layers 101 a, 102 may lose a bonding function with the ceramic substrate 10. Accordingly, it is desirable that the heating temperature (the target temperature) of the copper layers 103a, 104 should be equal to or lower than 900 °C.

Preferably, the temperature increase rate is 5 to 15 °C/min, more preferably, 10 °C/min. It is desirable that an atmosphere at the time of temperature increasing should be an inactive gas atmosphere, such as nitrogen or argon, or a vacuumed atmosphere. The pressure at the time of temperature increasing is not limited to any particular one, but if it is from an ambient pressure to a negative pressure (vacuum pressure) it is possible to safely process the ceramic wiring board 100 with a simple heat treatment.

After a temperature reaches a desired heat treatment temperature (the target temperature), in a step S17 in FIG. 4, for example, for equal to or longer than five minutes, preferably, for ten minutes or so, that temperature is held. It is preferable to set the hold time depending on the mass of each copper layer 103a, 104.

Next, in a step S18 in FIG. 4, the ceramic wiring board 100 is gradually cooled down. More specifically, cooling is slowly performed so as to promote crystal growth and so as not to apply thermal stress to the ceramic substrate 10. The cooling rate is preferably 15 to 25 °C/min, and more preferably, 20 °C/min. The pressure at the time of cooling is not limited to any particular one, but it is preferable that such pressure should be from an ambient pressure to a negative pressure (vacuum pressure), and the ceramic wiring board 100 is slowly cooled up to a room temperature.

Through the foregoing heat treatment and cooling process, the seed layers 101a, 102 become the seed layers 12, 22, respectively, and the copper layers 103a, 104 become the copper layers 13, 23, respectively. As a result, the first wiring conductor layer 11 comprising the seed layer 12 and the copper layer 13 and the second wiring conductor layer 21 comprising the seed layer 22 and the copper layer 23 are formed, and as shown in FIG. 6C, the ceramic wiring board 100 (see FIG. 2) of the embodiment is thus obtained.

According to the first manufacturing method of the present embodiment, the copper layers 103, 104 (see FIG. 5C) are formed by a low-temperature growth technique on the ceramic substrate 10, and patterned (see FIGS. 6A, 6B). Thereafter, the copper layers 103a, 104 are heated to a temperature equal to or higher than the annealing temperature of copper, and after this temperature increasing, the copper layers 103a, 104 are gradually cooled down, thereby forming the copper layers 13, 23 (see FIG. 6C). According to this manufacturing method, a crystal grain becomes large, and as a result, a grain boundary between crystal grains is reduced, so that the copper layers 13, 23 are softened. As the copper layers 13, 23 become soft, stress to the copper layers 13, 23 can be eliminated, making the ceramic substrate 10 not easily cracked.

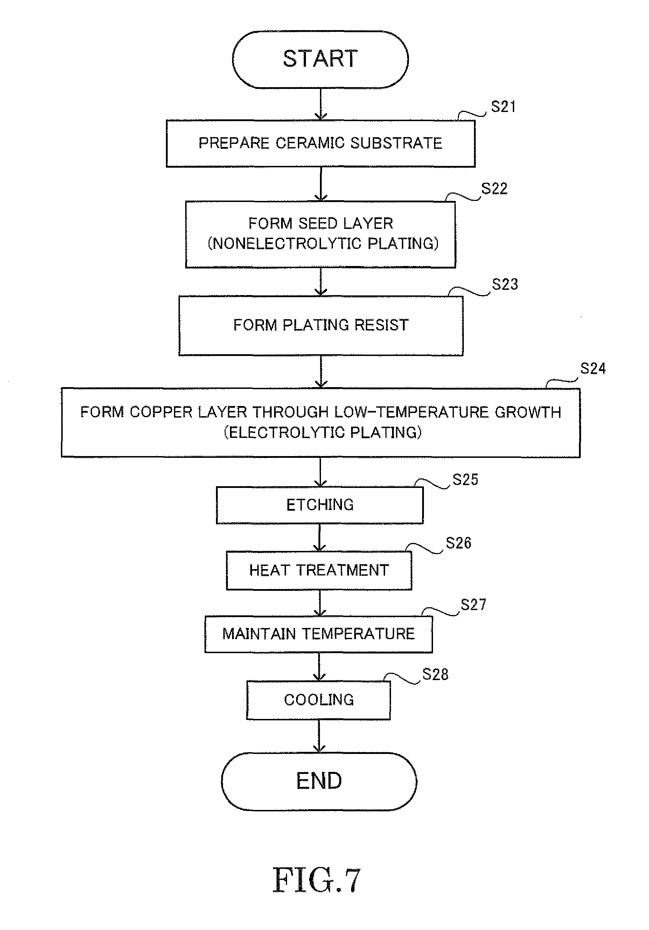

Next, with reference to FIG. 7, an explanation will be given of a second manufacturing method of the ceramic wiring board 100 of the present invention, and more specifically, the second manufacturing method which is different from the first manufacturing method. According to the second manufacturing method, how to form a wiring pattern is different from that of the first manufacturing method.

FIG. 7 is a flowchart showing steps of the second manufacturing method.

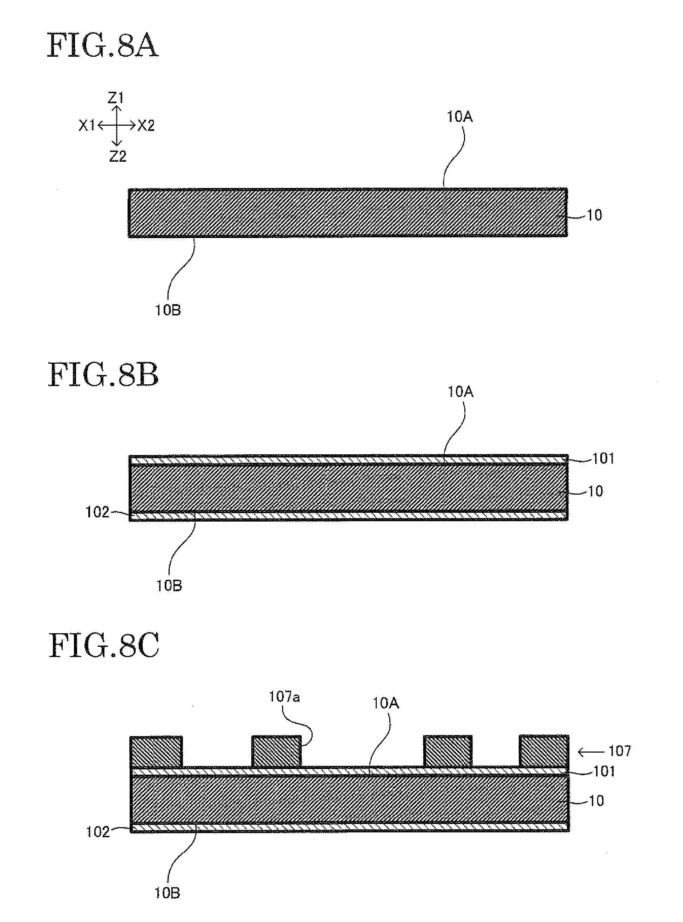

In a step S21, as shown in FIG. 8A, the ceramic substrate 10 is prepared.

Next, in a step S22 in FIG. 7, as shown in FIG. 8B, like the first manufacturing method, the seed layers 101, 102 made of a high-melting point metal are formed on respective whole first face 10A (front face) and second face 10B (rear face) of the ceramic substrate 10. Like the first manufacturing method, copper thin films may be formed on respective seed layers 101, 102 by sputtering after this step.

Subsequently, in a step S23 in FIG. 7, as shown in FIG. 8C, a photo resist 107 (plating resist) having an opening 107a at a predetermined location on the seed layer 101 is formed. The photo resist 107 forms an inverted pattern of a wiring pattern. Conversely, because no wiring pattern is formed at the seed-layer-102 side, no photo resist is formed on the seed layer 102.

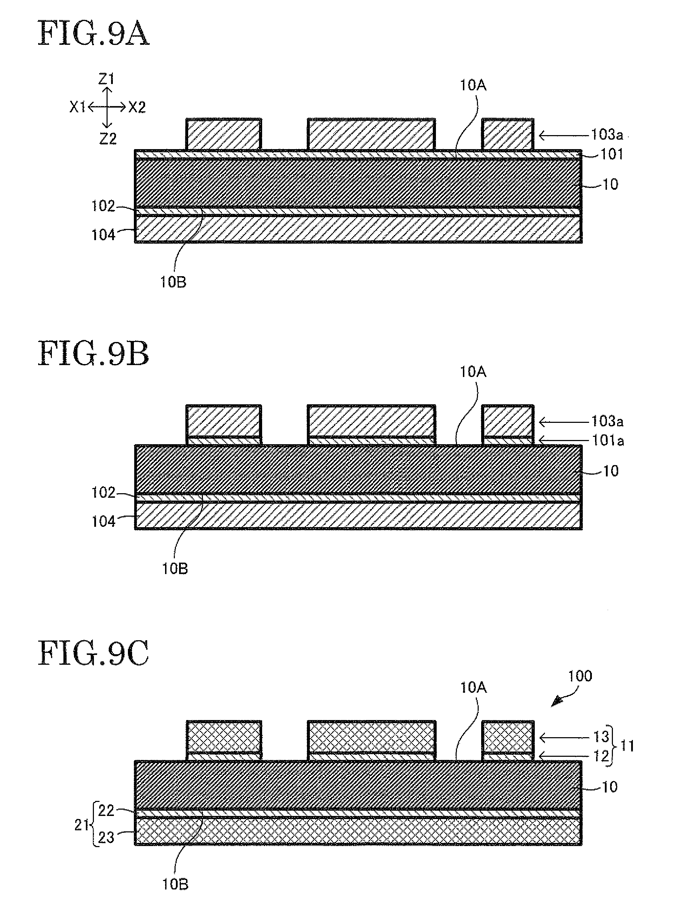

Next, in a step S24 in FIG. 7, as shown in FIG. 9A, through the same low-temperature growth technique as that of the first manufacturing method, a copper layer 103a is formed on the seed layer 101 exposed from the photo resist 107. Accordingly, the copper layer 103a configuring a wiring pattern is formed. Conversely, a copper layer 104 is formed on the whole seed layer 102. Thereafter, the photo resist 107 is eliminated.

Subsequently, in a step S25 in FIG. 7, as shown in FIG. 9B, portions of the seed layer 101 where no portion of copper layer 103 a is formed are eliminated. For example, only the seed layer 101 (e.g., titanium) is selectively eliminated. Moreover, in a case in which a copper thin film is formed on the seed layer 101 (see FIG. 10A to be discussed later), because the copper layer 103a can be formed thickly, through a soft etching technique using a mild etching liquid or a mild condition, the copper layer 103a and the seed layer 101 are etched together little by little, thereby eliminating portions of the seed layer 101 where no copper layer 103a is formed.

Next, in a step S26 in FIG. 7, like the first manufacturing method, a heat treatment of increasing the temperature of the ceramic wiring board 100 formed with the copper layers 103a, 104 to equal to or higher than the annealing temperature of copper is performed. Successively, like the first manufacturing method, in a step S27 in FIG. 7, the temperature is held for a certain time, and in a step S28, the ceramic wiring board 100 is gradually cooled down, thereby obtaining the ceramic wiring board 100 of the present embodiment as shown in FIG. 9C.

The first and second manufacturing methods of the present embodiment are appropriate for manufacturing of the ceramic wiring board 100. According to such manufacturing methods, a good ceramic wiring board 100 can be obtained at a low cost.

The ceramic wiring board 100 (see FIG. 2) of the present embodiment, in more detail, the ceramic wiring board 100 manufactured through the first or second manufacturing method has features that the substrate is not likely to be cracked and the wiring pattern is not likely to be delaminated even if a heat cycle is repeated although the copper layers 13, 23 are formed on the ceramic substrate 10. A detailed explanation will now be given of such features below.

The inventor of the present invention produced samples 1 and 2 (see FIG. 10A) as the ceramic wiring boards 100 of the present embodiment, and samples 3 and 4 (see FIG. 10B) as ceramic wiring boards of comparative examples, and evaluated an average grain radius or the like for each of the samples 1 to 4. Note that the samples 1 to 4 are produced through a technique based on the foregoing first manufacturing method of the present embodiment. However, a heating temperature (target temperature) at the time of temperature increasing of a copper layer on the ceramic substrate 10 was set to be 800 °C for the sample 1 (example 1), 600 °C for the sample 2 (example 2), and 350 °C for the sample 3 (comparative example 1), and no heat treatment itself was performed on the sample 4 (comparative example 2).

A ceramic wiring board 100 having the copper layers 13, 23, having undergone temperature increasing equal to or higher than the annealing temperature of copper according to the present embodiment is distinguished from a ceramic wiring board 200 having the copper layers 33, 43, not subjected to temperature increasing equal to or higher than the annealing temperature of copper according to a comparative example, and the former (samples 1 and 2) are shown in FIG. 10A, and the latter (samples 3 and 4) are shown in FIG. 10B, respectively. Note that the same structural elements as those shown in FIG. 2 or the like are denoted by the same reference numerals, and the common part explained already, i.e., portions with duplicated explanation will be omitted below to facilitate the explanation.

As shown in FIG. 10A, according to the samples 1 and 2 (examples 1 and 2), the copper layer 13 was comprised of a copper film 131, and an electrolytic plating film 132, and the copper layer 23 was comprised of a copper film 231, and an electrolytic plating film 232. That is, prior to electrolytic plating, the copper films 131, 231 were formed on respective seed layers 12, 22 by sputtering.

Moreover, as shown in FIG. 10B, according to the samples 3 and 4 (comparative examples 1 and 2), the copper layer 33 was comprised of a copper film 331, and an electrolytic plating film 332. The copper layer 43 was comprised of a copper film 431, and an electrolytic plating film 432. That is, prior to electrolytic plating, the copper films 331, 431 were formed on respective seed layers 32, 42 by sputtering.

A detailed explanation will now be given of how to manufacture the samples 1 to 4.

For manufacturing of the sample 1, first, a ceramic substrate 10 which was an aluminum nitride substrate was prepared (step S11 in FIG. 4, and FIG. 5A). Next, through sputtering for five to fifteen minutes with Ar plasma and DG4 to 5 kW conditions, seed layers 101, 102 formed of titanium (Ti) with a thickness of 0.1 $\mu$m were formed on both surfaces of the aluminum nitride substrate (step S12 in FIG. 4, and FIG. 5B). Subsequently, copper films (portions of copper layers 103, 104) with a thickness of 1.0 $\mu$m were formed on respective seed layers 101, 102 (step S13 in FIG. 4, and FIG. 5C). The seed layers 101, 102 and the foregoing copper films were formed on respective whole faces of the ceramic substrate 10 (aluminum nitride substrate).

Next, copper electrolytic plating films (remaining portions of copper layers 103, 104) were formed on respective whole copper films (copper sputtering films). More specifically, with the ceramic substrate 10 (aluminum nitride substrate) being as a cathode and a copper plate electrode being as an anode, the ceramic substrate 10 was dipped in a copper sulfate solution, and electrolytic copper plating with a current amount of 3A/dm$^2$ was carried out for 30 minutes. Accordingly, the copper layers 103, 104 were formed on respective seed layers 101, 102 (step S13 in FIG. 4, and FIG. 5C).

Subsequently, through a general exposure/developing technique, photo resists 105, 106 (etching resists) forming a wiring pattern were formed on predetermined locations on the electrolytic plating films (step S14 in FIG. 4, and FIG. 6A).

Next, portions of copper layers 103, 104 and seed layers 101, 102 exposed from the photo resists 105, 106 were eliminated by etching. Accordingly, a ceramic wiring board formed with a wiring pattern was obtained (step S15 in FIG. 4, and FIG. 6B).

Subsequently, using a heat treatment furnace, the foregoing ceramic wiring board was heated to 800 °C at a temperature increase rate of 10 °C/min and at an ambient pressure under a nitrogen atmosphere (step S16 in FIG. 4).

Thereafter, the ceramic wiring board was held at 800 °C for 10 minutes (step S17 in FIG. 4), and was (gradually) cooled to a room temperature at 20 °C/min (step S18 in FIG. 4). Accordingly, the sample 1 shown in FIG. 10A was obtained.

The sample 2 was produced through the same fashion as that of the sample 1 except that the heating temperature (step S16 in FIG. 4) was set to be 600 °C.

The sample 3 was produced through the same fashion as that of the sample 1 except that the heating temperature (step S16 in FIG. 4) was set to be 350 °C.

The sample 4 was produced through the same fashion as that of the sample 1 except that no heat treatment (step S16 in FIG. 4) was performed.

Next, how to evaluate the samples 1 to 4 and results thereof will be explained. For evaluation, calculation of a copper grain radius, a substrate crack test, and a delamination test were carried out.

For calculation of a copper grain radius, the samples 1 to 4 were each cut to a piece of about 5 mm by 5 mm, and such pieces were embedded in a room-temperature-curing type epoxy resin in such a way that the cross section of each piece was observable. Next, Pt-Pd sputtering was performed through a Cross-section Polisher (CP) technique, and a sample cross section was produced through ion polishing (6 kV × 6 hr). Subsequently, the sample was fixed on a sample stage, and observation was made through a scanning electron microscope (FE-SEM).

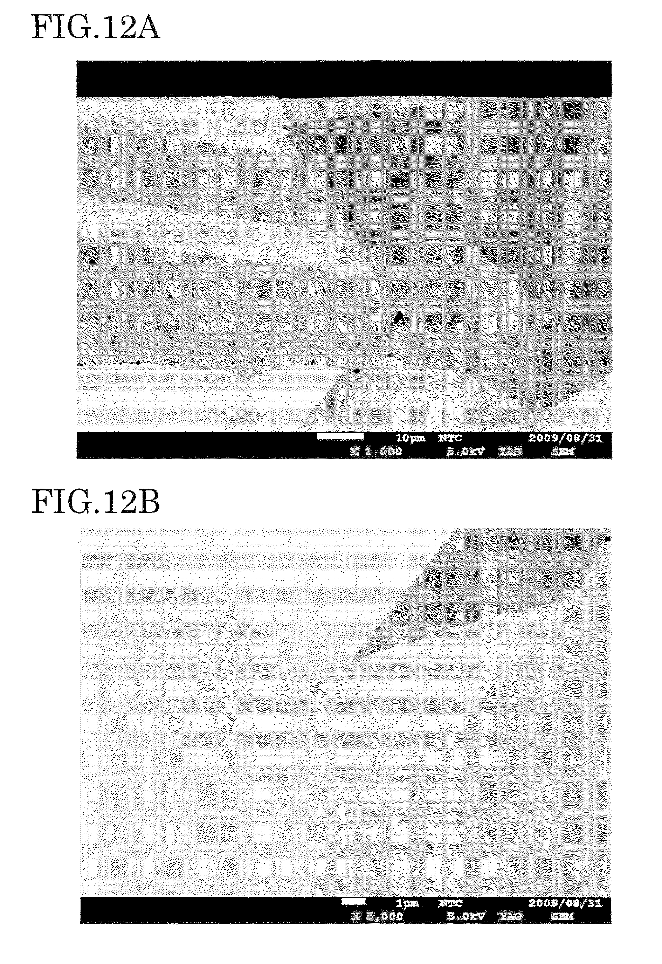

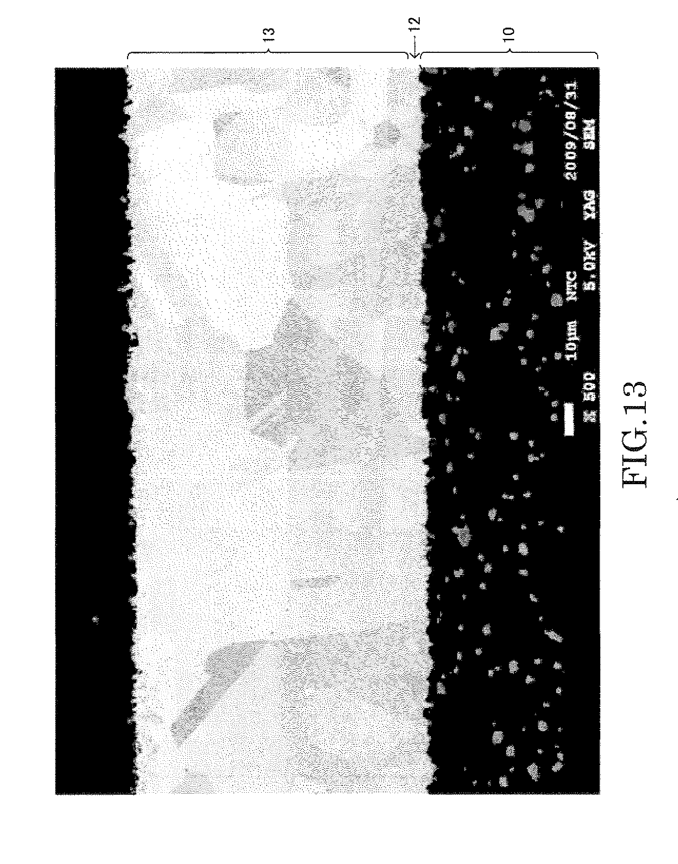

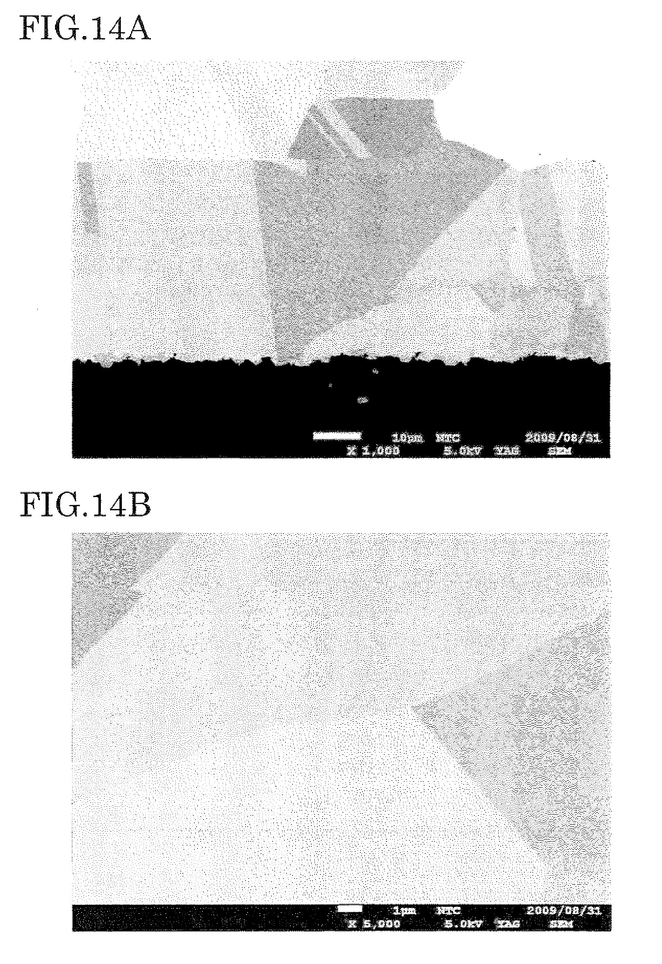

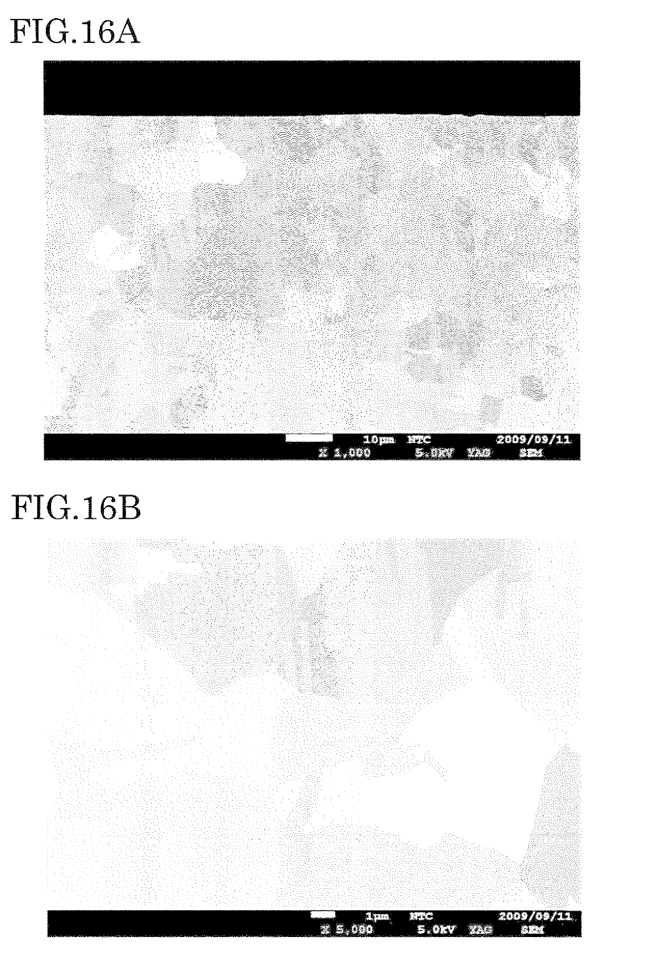

FIGS. 11 to 18B show SEM photographs picked up respective images of cross sections of the samples 1 to 4 through the foregoing technique. FIGS. 11 to 12B, FIGS. 13 to 14B, FIGS. 15 to 16B, and FIGS. 17 to 18B are SEM photographs of the sample the sample 2, the sample 3, and the sample 4, respectively. More specifically, FIGS. 11, 13, 15, and 17 are SEM photographs of a whole cross section at a magnification of 500, FIGS. 12A, 14A, 16A, and 18A are SEM photographs of a part of a copper layer at a magnification of 1000, and FIGS. 12B, 14B, 16B, and 18B are SEM photographs of a part of a copper layer at a magnification of 5000. Note that respective cross sections of the samples 1 to 4 shown in FIGS. 11 to 18B were prepared using SM-09010 (cross-section polisher apparatus) made by JEOL Ltd.. Moreover, in order to pickup SEM photographs of FIGS. 11 to 18B, JSM-7001F (FE-SEM) made by JEOL Ltd., was used, and an observed image was taken as a reflected electron image at an accelerating voltage of 5 kV.

According to the samples 1 and 2 (examples 1 and 2) having undergone a heat treatment at 800 °C or 600 °C, as shown in FIGS. 11 to 14B, adjoining crystals were integrated together so that a crystal size became large, and sufficient crystal growth was confirmed.

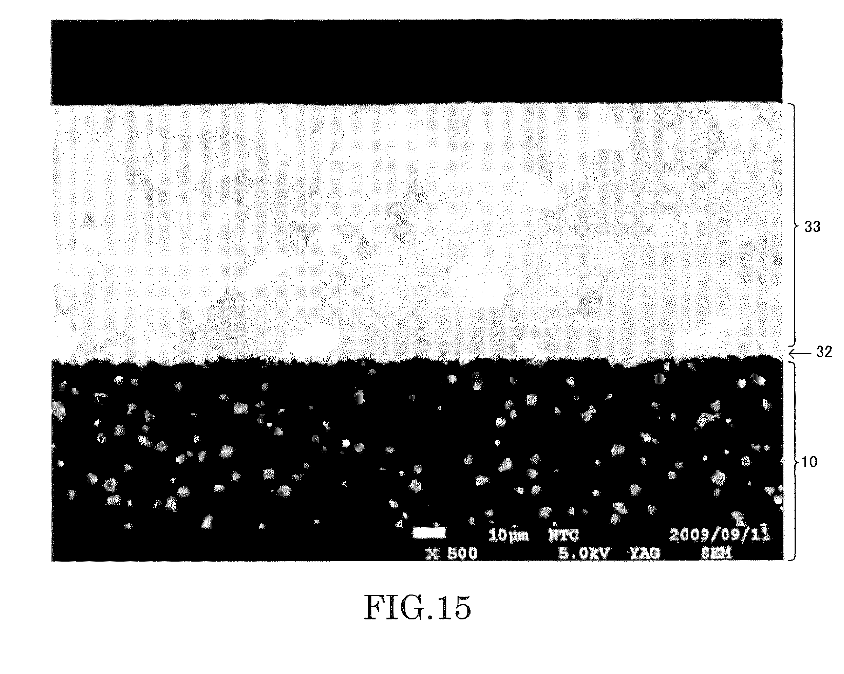

According to the sample 3 (comparative example 1) having undergone a heat treatment at 350 °C, as shown in FIGS. 15 to 16B, defects like transformation, etc. in a crystal grain were hardly found, and crystal orientations in individual crystals were slightly matched, but crystal growth was still insufficient.

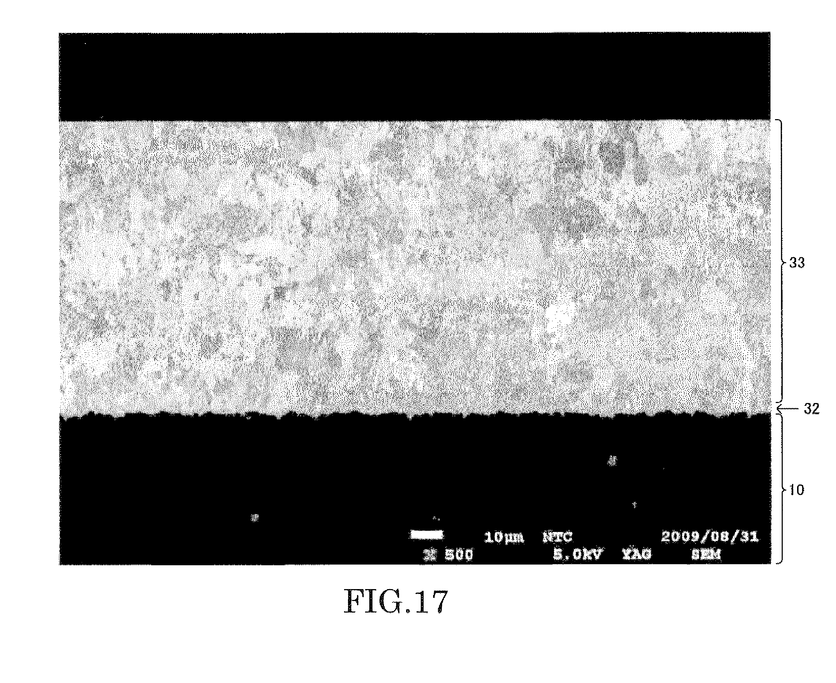

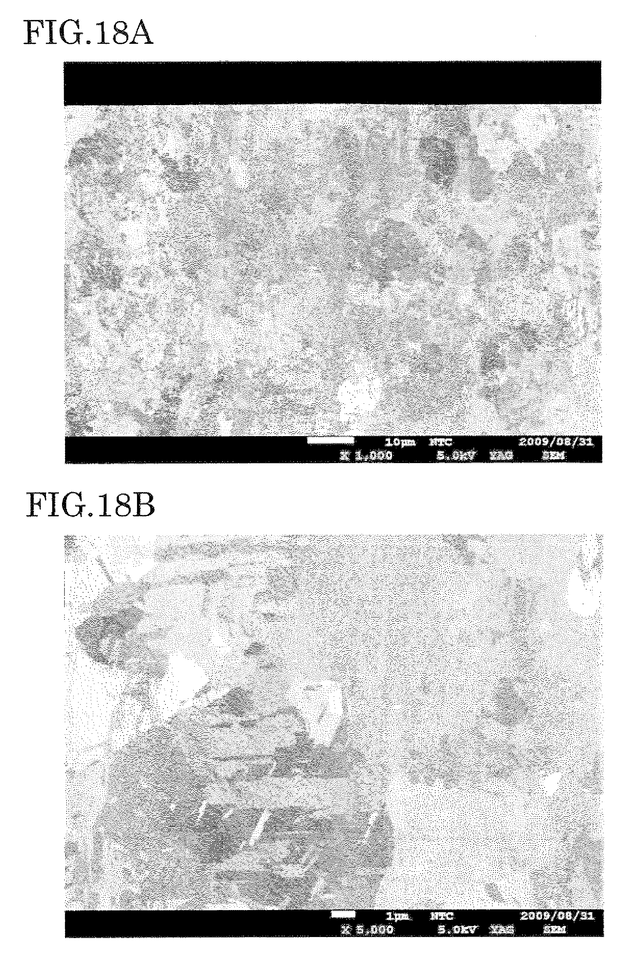

According to the sample 4 (comparative example 2) having undergone no heat treatment, as shown in FIGS. 17 to 18B, a large number of crystal defects were seen in a copper crystal grain, and it was difficult to make a discrimination between a boundary and a defect, and a copper crystal itself was unclear.

A copper grain radius was calculated based on the foregoing copper cross-sectional photographs (FIGS. 11 to 18B). More specifically, first, a rectangular region sufficiently larger than the size of a copper grain was selected at random, and with a premise that the count number for a copper crystal grain contained in the rectangular region is 1, and the count number for a grain present across a boundary line of the rectangle is 0.5, a total number is counted. Thereafter, a cross-sectional area of the rectangular region was divided by the number of crystals obtained thus way, thereby calculating an average cross-sectional area per crystal from the following formula (1).

[Formula 1]

$$\text{Average cross-sectional area} = \text{area of rectangular region/number}$$

Moreover, such average cross-sectional area obtained in this fashion was approximated as a circle, and an average grain radius of a copper crystal was obtained from the following formula (2).

[Formula 2]

$$\text{Average grain radius} = \sqrt{(\text{average cross-sectional area} \times 4/\pi)}$$

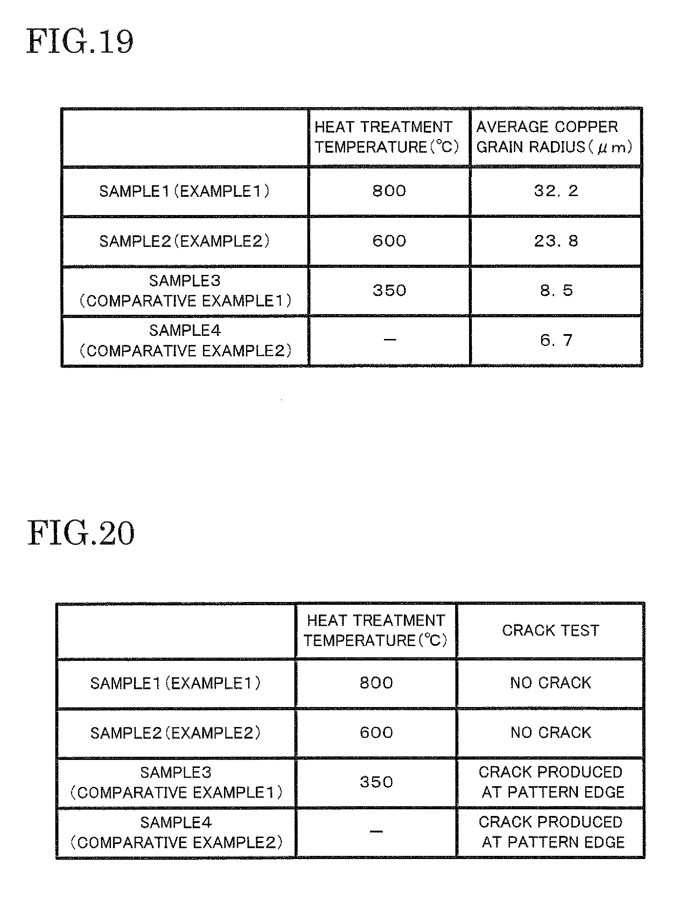

FIG. 19 shows a result of calculating an average copper grain radius for each of the samples 1 to 4. As shown in FIG. 19, the average copper grain radius was 32.2 $\mu$m in the case of the sample 1, 23.8 $\mu$m in the case of the sample 2, 8.5 $\mu$m in the case of the sample 3, and 6.7 $\mu$m in the case of the sample 4. Hence, according to the samples 1 and 2 (examples 1 and 2), the copper layers 13, 23 each having an average copper grain radius of equal to or larger than 10 $\mu$m were obtained. More specifically, according to the sample 2, an average copper grain radius of equal to or larger

than 20 μm was obtained, and according to the sample 1, an average grain radius of equal to or larger than 30 μm was obtained. In contrast, the average copper grain radius of each of the copper layers 13, 23, of the samples 3 and 4 (comparative examples 1 and 2) was less than 10 μm. As is clear from those results, according to the samples 1 and 2 (examples 1 and 2), temperature increasing to a temperature equal to or higher than the annealing temperature after formation of the copper layers 13, 23, and gradual cooling after the temperature increasing promote crystal growth of copper, so that a copper grain radius becomes equal to or larger than 10 μm. Accordingly, stress to the copper layers 13, 23 is sufficiently eliminated, and as will be described below, the ceramic substrate 10 becomes unlikely to be cracked and the copper layers 13, 23 become unlikely to be delaminated.

In the substrate crack test, a three-minute period was taken as a cycle, and the samples 1 to 4 were alternately put in a liquid-phase reservoir at a temperature of -65 °C, and a liquid-phase reservoir at a temperature of 150 °C by 1000 cycles, and evaluation was made for whether or not a crack was produced in the ceramic substrate 10. Note that for evaluation at -65 °C, ethanol and a freezing medium like a dry ice were used. Moreover, evaluation at 150 °C was carried out in an oil bath.

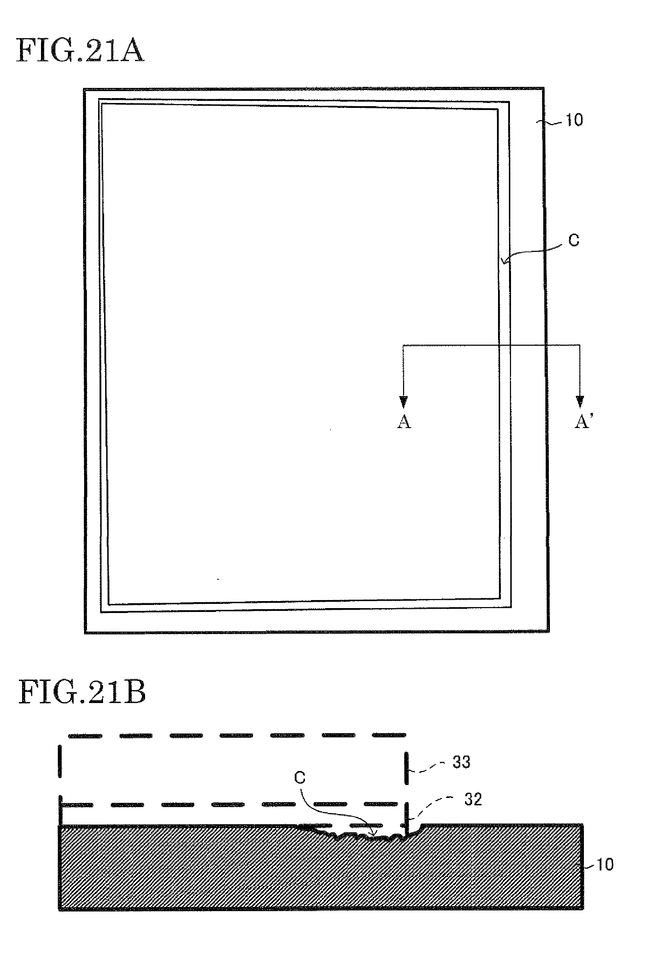

FIG. 20 shows a result of a substrate crack test for each of the samples 1 to 4. As shown in FIG. 20, according to the samples 1 and 2 (examples 1 and 2), no crack was produced. In contrast, according to the samples 3 and 4 (comparative examples 1 and 2), a crack was produced in the vicinity of an edge part of the copper layer 33 (pattern edge). This crack will be explained in more detail with reference to FIGS. 21A and 21B.

FIG. 21A is a plan view showing the sample 3 (comparative example 1) after a substrate crack test, and more specifically, a plan view showing the ceramic substrate 10 (aluminum nitride substrate) that corresponded to the ceramic wiring board 200 (see FIG. 10B) with the copper layer 33 and the seed layer 32 being eliminated by etching. FIG. 21B is an exemplary cross-sectional view along a line A-A' in FIG. 21A.

As shown in FIGS. 21A and 21B, it was confirmed that a crack C was formed in the ceramic substrate 10 (aluminum nitride substrate) in the vicinity of an edge of the copper layer 33 (pattern edge).

As explained above, according to the samples l and 2 (examples 1 and 2), any cracking of the ceramic substrate 10 is suppressed. The reason why is inferred as follows. That is, because the seed layers 12, 22 made of a high-melting-point metal are formed in the vicinity of a normal temperature and a copper wiring pattern is formed by an electrolytic plating technique, thermal stress becomes minimum in the vicinity of a room temperature. Accordingly, thermal strain produced by a heat cycle between the normal temperature and the use temperature becomes small, thereby making the ceramic substrate 10 to be unlikely cracked.

In the delamination test, before and after the heat treatment, i.e., before and after a heat cycle, reduction of an adhesiveness strength between the ceramic substrate 10 and the copper layer 23 or 43 was checked. More specifically, from the ceramic wiring board 100 or 200 (see FIGS. 10A and 10B), a plate-like sample 10 mm by 10 mm was produced so that the copper layer 23 or 43 was left on a whole one-side face, and both surfaces of such a sample were stuck to pull-test holders. Thereafter, using an auto graph (device name: AG-IS5kN) made by SHIMADZU corporation, a test was carried out at a pull rate of 1 mm/min, and for a boundary plane between the ceramic substrate 10 and the copper layer 23 or 43, a pull strength in a vertical direction was measured. In a case in which the copper layers are formed on both surfaces of the ceramic substrate 10, the copper layer at the one-side face is peeled in advance by etching or the like in order to carry out a delamination test. Moreover, in a case in which measurement is made by using a test piece having the copper layers formed on both surfaces of the ceramic substrate 10, it is not suitable as a comparison object because the copper layer at a side where a bonding strength is weak is always peeled.

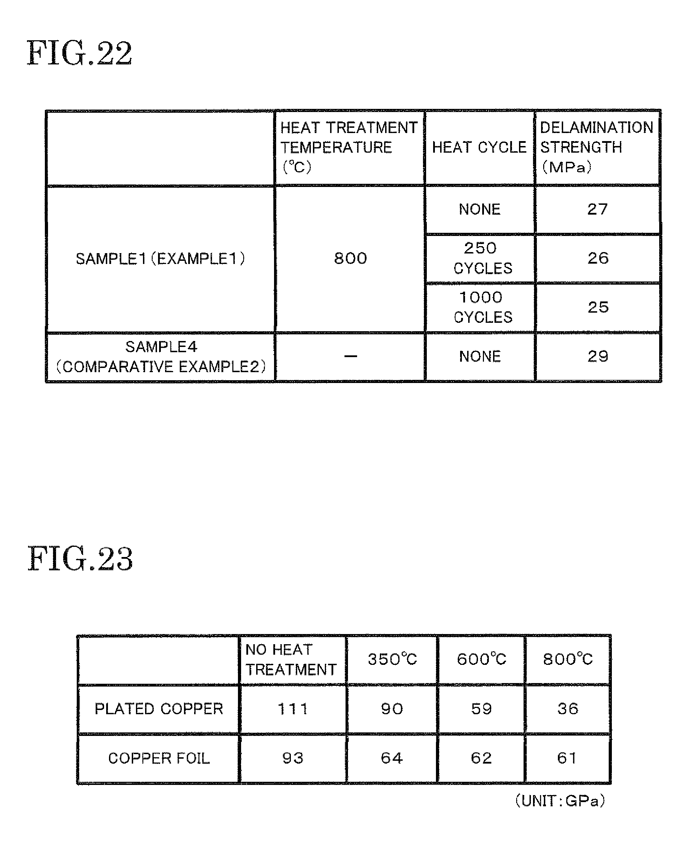

In order to check an enhancement of a delamination strength by a heat treatment, the sample 1 with the greatest heat treatment and the sample 4 were compared with each other. FIG. 22 shows results of respective delamination tests for the sample 1 (example 1) and the sample 4 (comparative example 2).

As shown in FIG. 22, according to the sample 1, there was substantially no change in a delamination strength before and after a heat-cycle test. Moreover, according to the example 1 having undergone a heat treatment at 800 °C, a delamination strength substantially same as that of the sample 4 having undergone no heat treatment was obtained. As is clear from this fact, respective delamination strengths of the copper layers 13, 23 of the sample 1 (example 1) were maintained well. According to the samples 1 and 2 (examples 1 and 2), as explained above, because thermal strain produced by a heat cycle between the normal temperature and the use temperature becomes small, the copper layers 13, 23 become unlikely to be delaminated.

As explained above, the ceramic wiring board 100 of the present embodiment has a feature that the substrate is not likely to be cracked and the wiring pattern is not likely to be delaminated although a heat cycle is repeated even though such a ceramic wiring board has the copper layers 13, 23 formed on the ceramic substrate 10.

Moreover, according to the ceramic wiring board 100 of the present embodiment, the copper layers 13, 23 are formed by a plating technique (see step S13 in FIG. 4 or step S24 in FIG. 7). This facilitates adjustment of the elastic modulus of each copper layer 13, 23. For example, as explained above, it is preferable that the elastic modulus of each copper layer 13, 23 should be within a range from 30 to 70 GPa, and according to the foregoing plating technique, it becomes easy to adjust the elastic modulus of each copper layer 13, 23 to be an arbitrary value within the foregoing range by changing a heat treatment temperature after plating. This effect will be explained in more detail in comparison with a growth layer (plated copper) formed by a plating technique and a copper foil which is not a growth layer.

The inventor of the present invention measured an elastic modulus for each of the plated copper and the copper foil. In this test, an elastic modulus (Young's modulus) after a heat treatment was measured.

For preparation of a sample of plated copper, first, a plated copper layer with a film thickness of 300 $\mu$m was formed on a stainless substrate by electrolytic plating. Next, a heat treatment at each temperature range was performed, the plated copper layer was peeled after gradual cooling, and a sample (test piece) of plated copper in a size 10 mm by 50 mm was prepared. In a case in which a copper layer is formed through a seed layer of titanium on the surface of an aluminum nitride substrate, it is difficult to peel, but if the substrate is cut so that aluminum nitride slightly remains on the surface of the copper layer by a diamond wire saw or the like and processed by a strong alkaline solution, a test piece with a copper layer for measurement of an elastic modulus can be prepared.

Conversely, a sample of copper foil was produced by directly performing a heat treatment on the copper foil without the copper foil being stuck to a ceramic substrate. The sample of copper foil was a test piece in a size 10 mm by 50 mm.

For each of the plated copper and the copper foil, four kinds of samples having undergone no heat treatment, having undergone a heat treatment at 350 °C, at 600 °C, and at 800 °C were prepared. How to apply a heat treatment to individual samples was same as those of the samples 1 to 4.

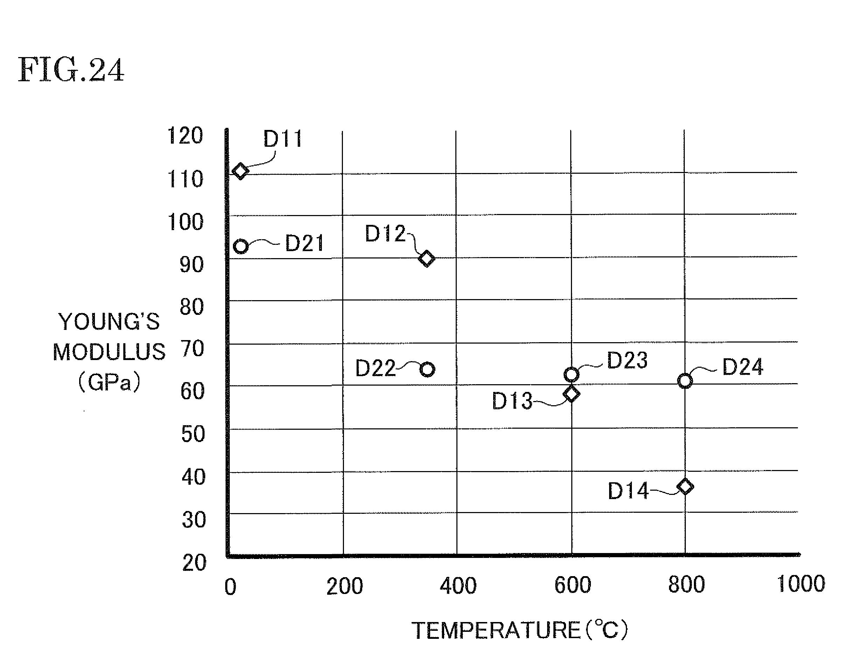

After each sample was prepared as explained above, and for each of the samples of plated copper and the sample of copper foil, an elastic modulus was measured by using an auto graph made by SHIMADZU Corporation. FIGS. 23 and 24 show measurement results. In the graph of FIG. 24, pieces of data D11 to D14 are for the plated copper, and pieces of data D21 to D24 are for the copper foil.

As shown in FIGS. 23 and 24, how the elastic modulus decreased was different between the plated copper and the copper foil, and in the case of the copper foil, the elastic modulus remained near 60 GPa from the heat treatment at equal to or higher than 350 °C, but in the case of plated copper, the elastic modulus decreased correlatively with increase of the heating temperature, and it was confirmed that the elastic modulus became smaller than that of the copper foil in the heat treatment at equal to or higher than 600 °C. Moreover, as a comprehensive tendency, it becomes clear from the graph in FIG. 24 (in particular, pieces of data D11 to D14) that the higher the heat treatment temperature becomes, the smaller the elastic modulus of the plated copper becomes. As the heat treatment temperature was set to be from 600 to 800 °C, the elastic modulus of the plated copper became a value within a range from 30 to 70 GPa. From this reason, according to the plating technique, it becomes easy to adjust the elastic modulus of each copper layer 13, 23 to be an arbitrary value within a range from 30 to 70 GPa by changing the heat treatment temperature after plating.

The present invention is not limited to the foregoing embodiment. For example, the present invention can be modified as follows to carry out the present invention.

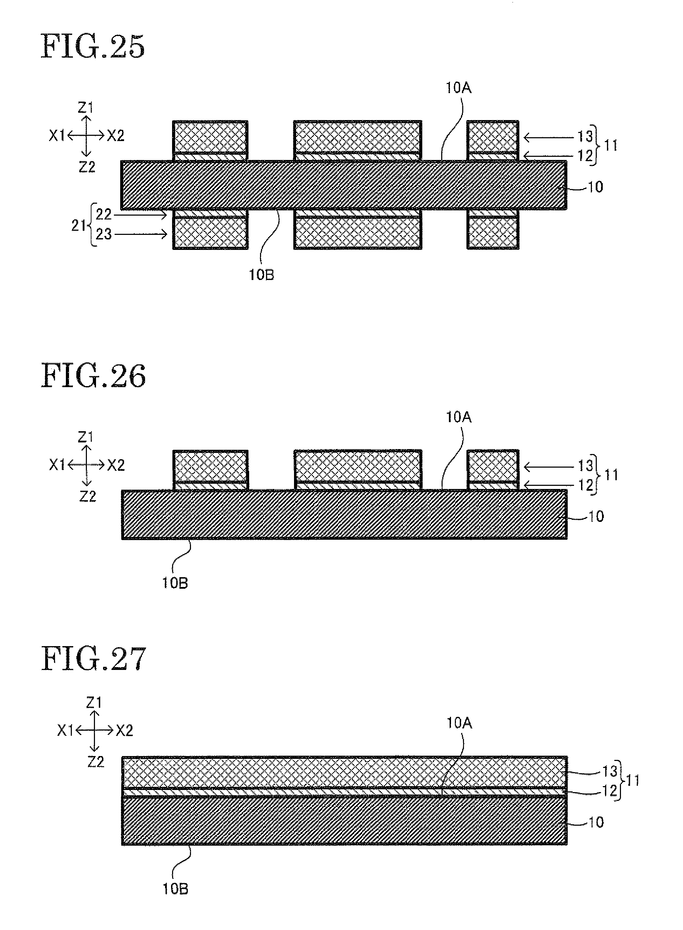

Both of the copper layers 13, 23 formed on both surfaces may configure respective wiring patterns. For example, as shown in FIG. 25, a second wiring conductor layer 21 formed on the second face 10B (rear face) of the ceramic substrate 10 may configure the same wiring pattern as that of the first wiring conductor layer 11 formed on the first face 10A (front face). In this fashion, as the ceramic substrate 10 has the same wiring patterns on both surfaces thereof, thermal strain acts on front and rear surfaces of the ceramic substrate 10 substantially symmetrically. Accordingly, cracking of the ceramic substrate 10 can be further suppressed. Moreover, as the wiring conductor layers are formed not only on the front face but also on the rear face, the wiring area can be increased.

In order to manufacture the ceramic wiring board shown in FIG. 25, first, in the steps S14 and S15 (see FIGS. 6A and 6B) in the foregoing first manufacturing method (see FIG. 4), the copper layer 104 and the seed layer 102 are partially eliminated by using photo resists corresponding to a wiring pattern not only at the first-face-10A (front face) side but also at the second-face-10B (rear face) side. Other procedures are same as those of the first manufacturing method. Alternatively, in the steps S23 and S24 (see FIGS. 8C and 9A) in the foregoing second manufacturing method (see FIG. 7), not only the seed layer 101 formed on the first-face-10A (front face) side of the ceramic substrate 10 but also the seed layer 102 formed on the second-face-10B (rear face) side are partially covered by photo resists for forming an inverted pattern of a wiring pattern, and electrolytic plating is performed on the ceramic substrate 10. Other procedures are same as those of the second manufacturing method.

As shown in FIG. 26, the ceramic wiring board may have a first wiring conductor layer 11 forming a wiring pattern on the first face 10A (front face) of the ceramic substrate 10, but have no wiring conductor layer on the second face 10B (rear face).

In order to manufacture the ceramic wiring board shown in FIG. 26, first, in the steps S12 and S13 (see FIGS. 5B and 5C) in the foregoing first manufacturing method (see FIG. 4) or in the steps S22 to S24 (see FIGS. 8B to 9A) in the foregoing second manufacturing method (see FIG. 7), no seed layer 102 and copper layer 104 are formed on the second-face-10B (rear face) side of the ceramic substrate 10, and other procedures are same as those of the first or second manufacturing method.

As shown in FIG. 27, a first wiring conductor layer 11 of a solid pattern (stress relief layer) maybe formed on one-side face of the ceramic substrate 10. Moreover, it is not illustrated in the figure but a first wiring conductor layer 11 of a solid pattern (stress relief layer) and a second wiring conductor layer 21 of a solid pattern (stress relief layer) may be formed on the first face 10A and the second face 10B of the ceramic substrate 10, respectively. According to such a ceramic wiring board, because each of the copper layers 13, 23 has the average copper grain radius and the elastic modulus as explained above, or because each of the copper layers 13, 23 is formed through the low-temperature growth technique and is subjected to a heat treatment, etc., as explained above, the same effect as that of the ceramic wiring board 100 of the foregoing embodiment or an effect based on the foregoing effect can be accomplished.

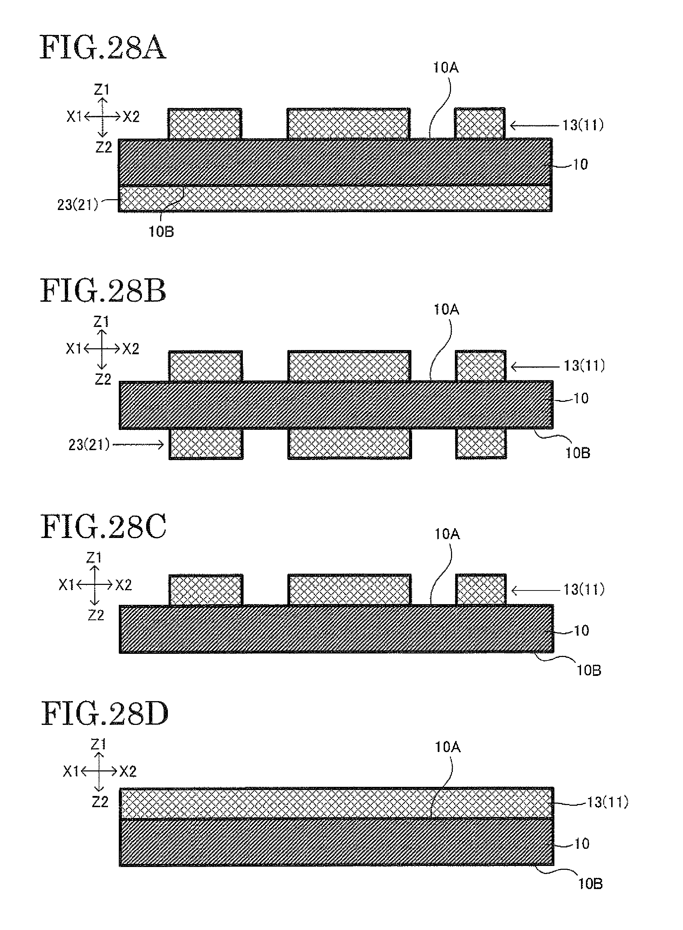

As shown in FIGS. 28A to 28D, the seed layer 12 or 22 between the ceramic substrate 10 and the first wiring conductor layer 11 or the second wiring conductor layer 21 may be omitted. According to the ceramic wiring board employing such a structure, because the copper layer 13 or 23 is directly formed on the ceramic substrate 10 with the seed layer 12 or 22 not intervening, it is difficult to secure the adhesiveness between the ceramic substrate 10 and the copper layer 13 or 23. Accordingly, in order to enhance the adhesiveness, the first face 10A (front face) is made rough with an Ra equal to or larger than, preferably, 0.5 $\mu$m, and more preferably, equal to or larger than 1 $\mu$m, and it is preferable to form the copper layer 13 or 23 thereon.

Regarding other characteristics, the structures (structural elements, dimensional size, material, shape, number of layers, or arrangement thereof, etc.,) of the ceramic wiring board 100 can be changed or omitted without departing from the scope and the spirit of the present invention.

The manufacturing method of the present invention is not limited to the content and the order shown in the flowchart of FIG. 4 or 7, and the content and the order can be changed optionally without departing from the scope and the spirit of the present invention. Moreover, unnecessary steps may be omitted depending on an application.

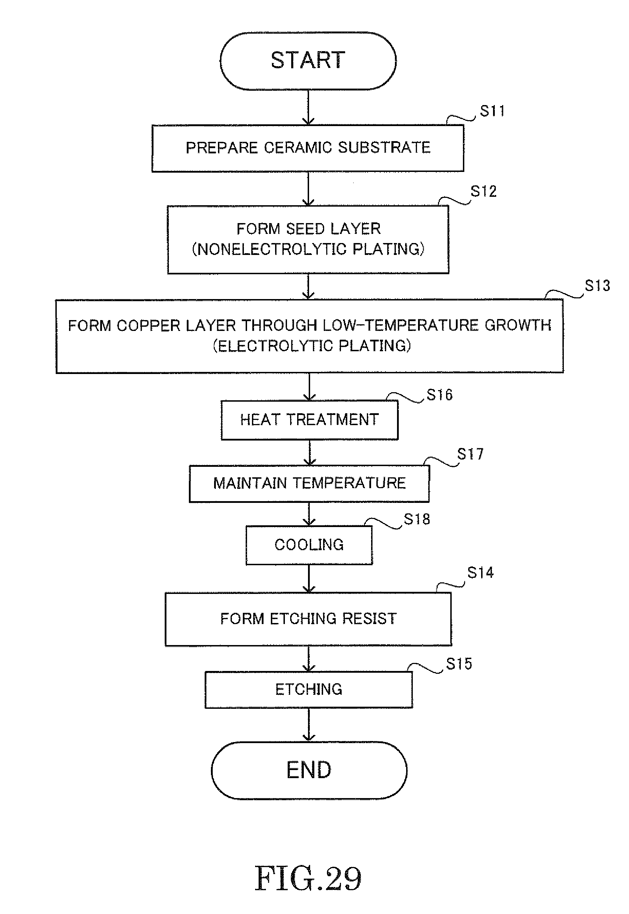

For example, as shown in FIG. 29, in the foregoing first manufacturing method (see FIG. 4), the heat treatment steps (steps S16 to S18) may be executed prior to etching of the copper layer (steps S14 and S15).

Moreover, in order to manufacture the ceramic wiring board shown in FIGS. 28A to 28D, because no seed layers 12, 22 are formed, the step of forming the seed layer (step S12 in FIG. 4 or step S22 in FIG. 7) can be omitted.

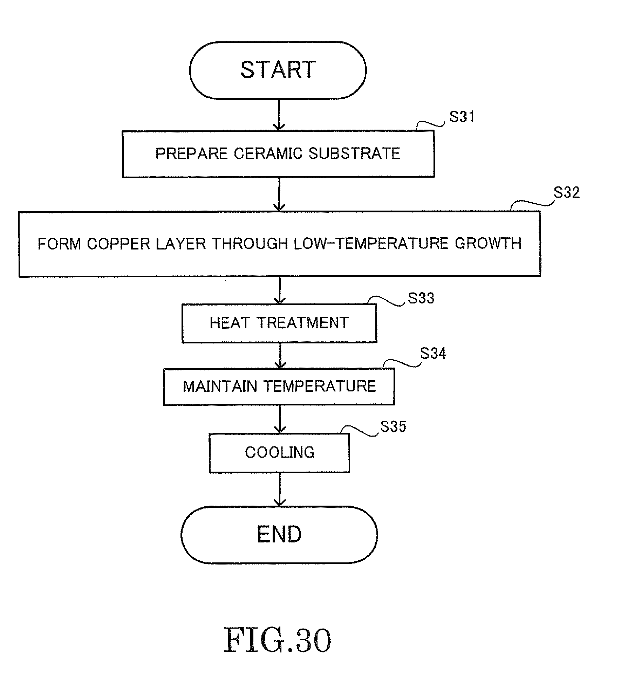

Furthermore, in order to manufacture the ceramic wiring board shown in FIG. 28D, as shown in FIG. 30, because it is not necessary to pattern the copper layer, the manufacturing method may comprise preparation of the ceramic substrate 10 (step S31), formation of the copper layer through the low-temperature growth technique (step S32), and heat treatment (steps S33 to S35) only.

How to form the copper layer is optional. For example, the copper layer can be formed through either one of a panel plating technique, a pattern plating technique, a full-additive technique, a semi-additive technique (SAP) (refer to second manufacturing method), a subtractive technique (refer to first manufacturing method), and tenting technique, or a combination of equal to or greater than two of those.

How to process the copper layer is also optional, and for example, the copper layer may be processed by a laser, etc., instead of etching.

The embodiment of the present invention was explained above, but it should be understood that various modifications and combinations necessary from the standpoint of designing and from other factors are included in the scope and the spirit of the present invention set forth in claims and of the invention corresponding to the specific example described in the embodiment.

The ceramic wiring board of the present invention is appropriate for circuit boards for power devices. Moreover, the manufacturing method of the ceramic wiring board of the present invention is appropriate for manufacturing of circuit boards for power devices.

Various embodiments and changes may be made thereunto without departing from the broad spirit and scope of the invention. The above-described embodiment is intended to illustrate the present invention, not to limit the scope of the present invention. The scope of the present invention is shown by the attached claims rather than the embodiment. Various modifications made within the meaning of an equivalent of the claims of the invention and within the claims are to be regarded to be in the scope of the present invention.

**Claims**

1. A manufacturing method of a ceramic wiring board **characterized by** including steps of:

    forming a copper layer (13) on a ceramic substrate (10) by a low-temperature growth technique;
    increasing a temperature of the copper layer (13) at equal to or higher than an annealing temperature of copper; and
    cooling the copper layer (13) after the temperature increasing.

2. The manufacturing method of a ceramic wiring board according to claim 1, **characterized in that** a temperature of the temperature increasing performed on the copper layer (13) is from 600 to 900 °C.

3. The manufacturing method of a ceramic wiring board according to claim 1 or 2, **characterized in that** a seed layer (12) made of a high-melting-point metal is formed prior to formation of the copper layer (13).

4. The manufacturing method of a ceramic wiring board according to any one of claims 1 to 3, **characterized in that** the low-temperature growth technique is a plating technique.

5. The manufacturing method of a ceramic wiring board according to any one of claims 1 to 4, **characterized in that** a cooling rate of the copper layer (13) is from 15 to 25 °C/min.

6. A ceramic wiring board **characterized by** comprising:

   a ceramic substrate (10);
   a copper layer (13) formed on the ceramic substrate (10);
   wherein an average copper grain radius in the copper layer (13) is equal to or larger than 10 $\mu$m.

7. The ceramic wiring board according to claim 6, **characterized in that** the copper layer (13) has an elastic modulus of from 30 to 70 GPa.

8. The ceramic wiring board according to claim 6 or 7, **characterized in that** the copper layer (13) is a copper growth layer.

9. The ceramic wiring board according to any one of claims 6 to 8, **characterized in that** the copper layer (13) is formed on the ceramic substrate (10) via a seed layer (12) made of a high-melting-point metal.

10. The ceramic wiring board according to any one of claims 6 to 9, **characterized in that** the copper layer (13) is formed on both surfaces of the ceramic substrate (10).

11. The ceramic wiring board according to claim 10, **characterized in that** both copper layers (13) formed on both surfaces of the ceramic substrate (10) each configures a wiring pattern.

12. The ceramic wiring board according to claim 10, **characterized in that** either one of the copper layers (13) formed on both surfaces of the ceramic substrate (10) is a stress relief layer.

13. The ceramic wiring board according to any one of claims 6 to 12, **characterized in that** the copper layer (13) is formed on the ceramic substrate (10) having a surface made rough with an Ra of equal to or larger than 0.5 $\mu$m.

14. The ceramic wiring board according to any one of claims 6 to 13, **characterized in that** the copper layer (13) has a thickness of equal to or thicker than 200 $\mu$m.

15. The ceramic wiring board according to any one of claims 6 to 14, **characterized in that** the copper layer (13) configures a wiring for a power device.

FIG.1

FIG.2

FIG.3

EP 2 306 501 A2

START

PREPARE CERAMIC SUBSTRATE ⌇S11

FORM SEED LAYER
(NONELECTROLYTIC PLATING) ⌇S12

FORM COPPER LAYER THROUGH LOW-TEMPERATURE GROWTH
(ELECTROLYTIC PLATING) ⌇S13

FORM ETCHING RESIST ⌇S14

ETCHING ⌇S15

HEAT TREATMENT ⌇S16

MAINTAIN TEMPERATURE ⌇S17

COOLING ⌇S18

END

FIG.4

FIG.5A

FIG.5B

FIG.5C

# FIG.6A

# FIG.6B

# FIG.6C

START

PREPARE CERAMIC SUBSTRATE — S21

FORM SEED LAYER
(NONELECTROLYTIC PLATING) — S22

FORM PLATING RESIST — S23

FORM COPPER LAYER THROUGH LOW-TEMPERATURE GROWTH
(ELECTROLYTIC PLATING) — S24

ETCHING — S25

HEAT TREATMENT — S26

MAINTAIN TEMPERATURE — S27

COOLING — S28

END

FIG.7

FIG.8A

FIG.8B

FIG.8C

# FIG.9A

# FIG.9B

# FIG.9C

# FIG.10A

# FIG.10B

FIG.11

FIG.12A

FIG.12B

FIG.13

FIG.14A

FIG.14B

FIG.15

# FIG.16A

# FIG.16B

FIG.17

## FIG.18A

## FIG.18B

# FIG.19

|  | HEAT TREATMENT TEMPERATURE(°C) | AVERAGE COPPER GRAIN RADIUS($\mu$m) |
|---|---|---|
| SAMPLE1(EXAMPLE1) | 800 | 32. 2 |
| SAMPLE2(EXAMPLE2) | 600 | 23. 8 |
| SAMPLE3 (COMPARATIVE EXAMPLE1) | 350 | 8. 5 |
| SAMPLE4 (COMPARATIVE EXAMPLE2) | — | 6. 7 |

# FIG.20

|  | HEAT TREATMENT TEMPERATURE(°C) | CRACK TEST |
|---|---|---|
| SAMPLE1(EXAMPLE1) | 800 | NO CRACK |
| SAMPLE2(EXAMPLE2) | 600 | NO CRACK |
| SAMPLE3 (COMPARATIVE EXAMPLE1) | 350 | CRACK PRODUCED AT PATTERN EDGE |
| SAMPLE4 (COMPARATIVE EXAMPLE2) | — | CRACK PRODUCED AT PATTERN EDGE |

## FIG.21A

## FIG.21B

## FIG.22

| | HEAT TREATMENT TEMPERATURE (°C) | HEAT CYCLE | DELAMINATION STRENGTH (MPa) |
|---|---|---|---|
| SAMPLE1 (EXAMPLE1) | 800 | NONE | 27 |
| | | 250 CYCLES | 26 |
| | | 1000 CYCLES | 25 |
| SAMPLE4 (COMPARATIVE EXAMPLE2) | — | NONE | 29 |

## FIG.23

| | NO HEAT TREATMENT | 350°C | 600°C | 800°C |
|---|---|---|---|---|
| PLATED COPPER | 111 | 90 | 59 | 36 |
| COPPER FOIL | 93 | 64 | 62 | 61 |

(UNIT:GPa)

EP 2 306 501 A2

# FIG.24

FIG.25

FIG.26

FIG.27

FIG.28A

10A

Z1
X1 ←→ X2
Z2

13(11)

10

23(21)

10B

FIG.28B

10A

Z1
X1 ←→ X2
Z2

13(11)

10

23(21)

10B

FIG.28C

10A

Z1
X1 ←→ X2
Z2

13(11)

10

10B

FIG.28D

10A

Z1
X1 ←→ X2
Z2

13(11)

10

10B

START

|
v
PREPARE CERAMIC SUBSTRATE — S11

|
v
FORM SEED LAYER
(NONELECTROLYTIC PLATING) — S12

|
v
FORM COPPER LAYER THROUGH LOW-TEMPERATURE GROWTH
(ELECTROLYTIC PLATING) — S13

|
v
HEAT TREATMENT — S16

|
v
MAINTAIN TEMPERATURE — S17

|
v
COOLING — S18

|
v
FORM ETCHING RESIST — S14

|
v
ETCHING — S15

|
v
END

# FIG.29

START

S31

PREPARE CERAMIC SUBSTRATE

S32

FORM COPPER LAYER THROUGH LOW-TEMPERATURE GROWTH

S33

HEAT TREATMENT

S34

MAINTAIN TEMPERATURE

S35

COOLING

END

FIG.30

**EP 2 306 501 A2**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001217362 A
- JP H104156 B
- JP S6459986 B
- JP 2003017837 A